(19) **Europäisches Patentamt / European Patent Office / Office européen des brevets**

(11) **EP 1 280 184 B1**

(12) **EUROPÄISCHE PATENTSCHRIFT**

(45) Veröffentlichungstag und Bekanntmachung des Hinweises auf die Patenterteilung:
**28.03.2007 Patentblatt 2007/13**

(51) Int Cl.:
*H01J 37/28* (2006.01)          *H01J 37/285* (2006.01)
*H01J 37/147* (2006.01)

(21) Anmeldenummer: **02014643.7**

(22) Anmeldetag: **02.07.2002**

(54) **Untersuchungssystem zum teilchenoptischen Abbilden eines Objekts, Ablenkvorrichtung für geladene Teilchen sowie Verfahren zum Betrieb derselben**

Inspecting system for particle-optical imaging of an object, deflection device for charged particles and method for operating the same

Système d'inspection d'optique corpusculaire pour l'imagerie d'un objet, dispositif pour la déflection des particules chargées et procédé pour son fonctionnement

(84) Benannte Vertragsstaaten:
**CZ DE FR GB IT NL**

(30) Priorität: **02.07.2001 DE 10131931**
 **14.12.2001 DE 10161526**

(43) Veröffentlichungstag der Anmeldung:
**29.01.2003 Patentblatt 2003/05**

(73) Patentinhaber: **Carl Zeiss SMT AG**
**73446 Oberkochen (DE)**

(72) Erfinder:
• **Kienzle, Oliver, Dr.**
 **73430 Aalen (DE)**
• **Stenkamp, Dirk, Dr.**
 **73457 Essingen (DE)**
• **Steigerwald, Michael, Dr.**
 **73434 Aalen (DE)**
• **Knippelmeyer, Rainer, Dr.**
 **73431 Aalen (DE)**

• **Haider, Max, Dr.**
 **69251 Gaiberg (DE)**
• **Müller, Heiko, Dr.**
 **69126 Heidelberg (DE)**
• **Uhlemann, Stephan, Dr.**
 **69115 Heidelberg (DE)**

(74) Vertreter: **Schorr, Frank Jürgen et al**
**Diehl & Partner,**
**Augustenstrasse 46**
**80333 München (DE)**

(56) Entgegenhaltungen:
WO-A-99/09582          US-A- 4 769 543
US-A- 6 087 659          US-B1- 6 184 526

• PATENT ABSTRACTS OF JAPAN vol. 1999, no. 11, 30. September 1999 (1999-09-30) & JP 11 162384 A (HITACHI LTD), 18. Juni 1999 (1999-06-18)

**Beschreibung**

Die Erfindung betrifft ein Untersuchungssystem zur zweidimensionalen Abbildung von Strukturen eines Objekts mittels geladener Teilchen, wie etwa Elektronen, auf einen Empfänger, wie etwa eine Kamera. Die untersuchten Strukturen können dabei insbesondere solche sein, wie sie herkömmlicherweise elektronenmikroskopisch untersucht werden, wobei von dem Objekt austretende Rückstreuelektronen, Sekundärelektronen, Transmissionselektronen oder Photoelektronen beobachtet werden. Die Erfindung soll dabei nicht auf diese Arten von Elektronen beschränkt sein, insbesondere ist auch an die Beobachtung von aus dem Objekt austretenden Ionen gedacht.

Die Erfindung betrifft ferner ein Untersuchungssystem mit einer Ablenkvorrichtung für Strahlen geladener Teilchen, welche insbesondere in dem Untersuchungssystem zur Untersuchung des Objekts einsetzbar ist.

Ein möglicher Einsatzbereich des Untersuchungssystem liegt in Verfahren zur Herstellung miniaturisierter Bauelemente und dabei insbesondere in der Lokalisierung von Defekten an den Bauelementen während der Fertigung derselben und an hierfür verwendeten Masken, wie etwa Lithographiemasken.

US 5,578,821 offenbart hierzu ein Untersuchungssystem, bei dem ein Elektronenstrahl auf einen Punkt (Pixel) des zu untersuchenden Objekts fokussiert wird, und von dem Objekt austretende Rückstreuelektronen, Sekundärelektronen und Transmissionselektronen durch entsprechende Detektoren registriert werden. Hierbei ist eine Deflektoreinrichtung vorgesehen, um den Ort, an dem der fokussierte Strahl auf das Objekt trifft, zu verlagern, und die jeweiligen Detektoren empfangen unabhängig von der Verlagerung des Ortes integral sämtliche Rückstreu-, Sekundär- bzw. Transmissionselektronen. Die Detektoren arbeiten selbst nicht ortsauflösend, allerdings ist es möglich, ein ortsaufgelöstes Bild der Strukturen des Objekts zu erhalten, wenn die von einem Detektor registrierte Intensität dem durch die Deflektoreinrichtung bestimmten Punkt, an dem der Strahl auf das Objekt trifft, zugeordnet wird. Es wird dann der Strahl nacheinander durch Betätigen der Deflektoreinrichtung an die verschiedenen Orte (Pixel) des Objekts ausgelenkt, es werden die den verschiedenen Orten zugeordneten gemessenen Intensitäten registriert, und aus den nacheinander registrierten Intensitäten wird das räumliche Bild des Objekts zusammengesetzt. Dieses Verfahren ist sehr zeitaufwendig.

US 6,087,659 offenbart ein Untersuchungssystem, bei dem ein räumlich ausgedehntes Feld auf dem Objekt mit Primärelektronen bestrahlt wird und bei dem aus dem Objekt austretende Sekundärelektronen auf einen ortsauflösenden Detektor abgebildet werden. Hierdurch ist, im Unterschied zu dem in US 5,578,821 gezeigten System, ein sequentielles Abtasten von Pixeln mittels einer Deflektoreinrichtung nicht notwendig, es können vielmehr eine Vielzahl von Pixeln gleichzeitig erfaßt werden. Allerdings ist bei einer gewünschten hohen Vergrößerung der Abbildung das auf den Detektor abgebildete Feld zu klein, um ein Objekt von größerer räumlicher Ausdehnung auf einmal abbilden zu können. Es ist deshalb ein mechanischer Verschiebetisch für das Objekt vorgesehen, um dieses relativ zu dem beleuchteten Feld zu verlagern, so daß mit dem Detektor zeitlich nacheinander eine Vielzahl von Bildern des schrittweise verlagerten Objekts aufgenommen werden kann, um schließlich durch Zusammenfügen der mehreren Bilder eine Abbildung des gesamten Objekts zu erhalten. Dies ist wiederum zeitaufwendig und setzt außerdem einen Verschiebetisch voraus, dessen mechanische Präzision in etwa der gewünschten Auflösung der Abbildung entspricht.

Demgemäß ist es eine Aufgabe der vorliegenden Erfindung, ein Untersuchungssystem zum Abbilden eines Objekts vorzuschlagen, mit dem räumlich ausgedehnte Objekte vergleichsweise schnell abgebildet werden können.

Ferner ist es eine Aufgabe der Erfindung, ein solches Untersuchungssystem vorzuschlagen, bei dem Anforderungen an eine mechanische Verschiebung des Objekts relativ zu dem Untersuchungssystem reduziert sind.

Unter einem ersten Aspekt sieht die Erfindung ein Untersuchungssystem zum Abbilden eines in einer Objektebene anordenbaren Objekts vor, welches einen ortsauflösenden Detektor umfaßt, auf den geladene Teilchen, die in einem räumlich ausgedehnten Feld aus dem Objekt austreten, abgebildet werden.

Es ist ferner eine erste Deflektoreinrichtung vorgesehen, die ein änderbares Ablenkfeld bereitstellt, um den Bereich, der mittels der geladenen Teilchen auf den Detektor abgebildet wird, in der Ebene des Objekts zu verlagern. Die erste Deflektoreinrichtung dient dabei dazu, um die je nach Verlagerung des Bereichs in der Objektebene aus unterschiedlichen Richtungen in die erste Deflektoreinrichtung eintretenden geladenen Teilchen durch einen im wesentlichen festen vorbestimmten Strahlquerschnitt zu führen.

Dabei wird der Teilchenstrahl unabhängig von der Lage des abgebildeten Bereiches in der Objektebene stets auf einen selben Ausschnitt der Detektionsfläche des Detektors gelenkt. Der Projektionsort des abgebildeten Bereiches auf der Detektionsfläche verschiebt sich nicht, wenn der Bereich, der auf den Detektor abgebildet wird, verlagert wird. Insbesondere durchläuft der von dem Objekt emittierte Teilchenstrahl den festen Strahlquerschnitt unabhängig von der Lage des Bereiches immer-im wesentlichen in einer gleichen Richtung, beispielsweise parallel zu einer optischen Achse des Systems.

Nach Durchlaufen dieses von der Verlagerung des abgebildeten Bereichs in der Objektebene unabhängigen Strahlquerschnitts durchlaufen die geladenen Teilchen gegebenenfalls eine Optik zur Erhöhung der Abbildungsvergrößerung und treffen schließlich auf den ortsauflösenden Detektor. Aufgrund der Verlagerbarkeit des auf den Detektor abgebildeten Bereichs der Objektebene ist es möglich, Strukturen vergleichsweise großer Objekte räumlich abzubilden, ohne das Objekt relativ zu dem Untersuchungssystem mechanisch bewegen zu müssen.

Das Untersuchungssystem umfaßt ferner eine Beleuchtungseinrichtung, um dem Objekt Energie derart zuzuführen, daß geladene Teilchen von Orten des Objekts austreten, wobei diese austretenden Teilchen dann nachfolgend dem Detektor zugeführt werden, um das Abbild des Objekts zu erhalten. Die Energie kann dem Objekt in Form von geladenen Teilchen, insbesondere Elektronen, oder elektromagnetischer Strahlung (Licht) zugeführt werden. Entsprechend umfaßt die Beleuchtungseinrichtung dann eine Lichtquelle, wie etwa einen Laser, oder eine Teilchenquelle, insbesondere eine Elektronenquelle. Die aufgrund der Zuführung der Energie aus dem Objekt austretenden Teilchen sind vorzugsweise Photoelektronen bzw. Rückstreuelektronen, Sekundärelektronen oder Transmissionselektronen.

Das Untersuchungssystem umfaßt ferner eine Steuerung, um die erste Deflektoreinrichtung derart anzusteuern, daß der auf den Detektor abgebildete Bereich des Objekts geändert wird, wobei die Steuerung ferner dazu vorgesehen ist, die Beleuchtungseinrichtung anzusteuern, um das begrenzte Feld, in dem dem Objekt Energie zugeführt wird, gemeinsam mit dem auf den Detektor abgebildeten Bereich in der Ebene des Objekts zu verlagern. Vorzugsweise fällt das beleuchtete Feld mit dem auf den Detektor abgebildeten Bereich im wesentlichen zusammen.

Es wird somit nicht etwa dem gesamten Objekt Energie zugeführt. Vielmehr wird im Hinblick auf eine möglichst niedrige thermische Belastung des Objekts lediglich einem Bereich desselben Energie zugeführt. Hierdurch wird zusätzlich eine Reduktion des Teilchenstroms erzielt, wodurch zum Beispiel Raumladungseffekte verkleinert werden. Wenn das beleuchtete Feld und der abgebildete Bereich zusammenfallen, ist dann die thermische Belastung des Objekts nicht größer als im Hinblick auf die Erzeugung der Abbildung des Objekts unbedingt notwendig.

Vorzugsweise ist zwischen dem Objekt und dem Ort in dem Strahlengang, an dem die zu dem Detektor hin verlaufenden geladenen Teilchen durch den festen Strahlquerschnitt treten, eine erste Fokussierlinseneinrichtung vorgesehen, welche auf die von dem Objekt austretenden Teilchen die Wirkung einer fokussierenden Linse hat. Im Hinblick auf eine ausreichende Vergrößerung der Abbildung ist diese Fokussierlinseneinrichtung relativ nahe an dem Objekt anzuordnen. Zur Vermeidung von Abbildungsfehlern ist ferner bei Verwendung einer herkömmlichen rotationssymmetrischen Magnetlinse, deren Bohrungsdurchmesser relativ klein zu wählen, so daß bei dicht an dem Objekt angeordneter Rundlinse mit kleinem Bohrungsdurchmesser der Bereich, der auf den Detektor abgebildet wird, in der Ebene des Objekts nicht so weit auslenkbar, wie dies im Hinblick auf eine Abbildung großflächiger Objekte ohne mechanische Bewegung derselben relativ zu dem Untersuchungssystem gewünscht wäre. Deshalb werden hier als erste Fokussierlinseneinrichtung vorzugsweise Linseneinrichtungen eingesetzt, die von der magnetischen Rundlinse, wie sie in den übrigen Komponenten des Untersuchungssystems, wie beispielsweise einer Nachvergrößerungsoptik vor dem Detektor, einsetzbar ist, verschieden sind.

Eine bevorzugte mögliche Ausgestaltung der ersten Fokussierlinseneinrichtung, welche ihr fokussierendes Ablenkfeld über einen relativ großen Bereich quer zur Strahlrichtung bereitstellt, ist in DE 196 34 456 A1 beschrieben. Diese Fokussierlinseneinrichtung umfaßt eine Zylinderlinse und eine stationär zur Zylinderlinse angeordnete Quadrupollinse. Die Achse der Zylinderlinse ist quer zur Strahlrichtung angeordnet und fokussiert den Strahl in einer Richtung quer zur Achsrichtung der Zylinderlinse. Eine Hauptachse der Quadrupollinse fällt im wesentlichen mit der Achse der Zylinderlinse zusammen, und das Feld der Zylinderlinse und das Feld der Quadrupollinse wirken zusammen fokussierend auf geladene Teilchen, die die Linsenanordnung durchsetzen.

Eine weitere bevorzugte Ausgestaltung der ersten Fokussierlinseneinrichtung ist in DE 199 44 857 A1 beschrieben. Die dort offenbarte Fokussierlinseneinrichtung umfaßt ebenfalls eine Zylinderlinse, deren Achse sich quer zur Strahlrichtung erstreckt. Dem durch die Zylinderlinse bereitgestellten Ablenkfeld wird ebenfalls ein Quadrupolfeld überlagert, welches allerdings nicht stationär ist, sondern in Richtung der Zylinderachse verlagerbar ist. Hierzu umfaßt die Linsenanordnung eine Vielzahl von Elektroden, welche paarweise gegenüberliegend entlang der Zylinderachse angeordnet sind. An die Elektroden können selektiv Spannungen derart angelegt werden, daß diese an einer auswählbaren Stelle entlang der Zylinderachse ein elektrisches Feld mit Quadrupolsymmetrie bereitstellen. Beim Einsatz einer solchen ersten Fokussierlinseneinrichtung ist die Steuerung ferner dazu vorgesehen, daß der Ort des gerade bereitgestellten Quadrupolfeldes in etwa zentral bezüglich eines Bündels geladener Teilchen angeordnet ist, welche von dem auf den Detektor abgebildeten Bereich bei dessen entsprechender Auslenkung in der Ebene des Objekts ausgehen.

Ferner ist es bevorzugt, die erste Fokussierlinseneinrichtung als Linse mit variabler Achse ("variable axis lens") auszubilden. Eine solche Linse ist in dem Artikel "MOL ("Moving Objective Lens"), Optic 48 (1977), Seiten 255ff. von E. Goto et al. oder in US 4,376,249 beschrieben.

Eine bevorzugte Ausgestaltung der ersten Fokussierlinseneinrichtung als Magnetlinse mit variabler Achse ist in der Patentanmeldung DE 100 44 199.8 der Anmelderin und korrespondierender europäischer Anmeldung Nr. 01121374.1 beschrieben. Diese Fokussierlinseneinrichtung umfaßt eine Magnetlinse die ein statisches rotationssymmetrisches Ablenkfeld bereitstellt, sowie ferner eine Spulenanordnung, die innerhalb des rotationssymmetrischen Magnetfelds angeordnet ist und dort ein Dipolfeld einstellbarer Größe erzeugt. Die Überlagerung des rotationssymmetrischen Magnetfelds und des Dipolfelds, dessen Feldrichtung quer zur Symmetrieachse der Magnetlinse und Strahlrichtung ausgerichtet ist, führt zu einem ebenfalls rotationssymmetrischen fokussierenden Feld, dessen Symmetrieachse allerdings bezüglich der Symmetrieachse der statischen Linse in Abhängigkeit von der Stärke des Dipolfelds verlagert ist. Die Stärke des Dipolfelds und damit die Verlagerung der wirksamen optischen Achse der Fokussierlinseneinrichtung wird hierbei vorzugsweise ebenfalls durch die Steuerung derart eingestellt, daß die Achsverlagerung gemeinsam mit der Verlagerung des beleuchteten Feldes und des auf den Detektor abgebildeten Bereichs des Objekts in der Objektebene erfolgt.

Vorzugsweise erfolgt die Ansteuerung dabei derart, daß die optische Achse des von der ersten Fokussierlinseneinrichtung bereitgestellten Fokussierlinsenfeldes den auf den Detektor abgebildeten Bereich insbesondere zentral schneidet.

Vorzugsweise ist das Untersuchungssystem derart ausgelegt, daß aus dem Objekt austretende Rückstreuelektronen oder/und Sekundärelektronen oder/und Transmissionselektronen oder/und Photoelektronen auf den entsprechenden Detektor abgebildet werden.

Zur Abbildung von Photoelektronen auf den Detektor umfaßt die Beleuchtungseinrichtung dann eine Photonenquelle, um das Feld in der Objektebene zu beleuchten. Die von der Photonenquelle emittierten Photonen werden hierbei vorzugsweise auf eine bewegbare Ablenkeinrichtung gerichtet, die die Photonen auf das Objekt reflektiert. Die Bewegung der Ablenkeinrichtung wird durch die Steuerung kontrolliert, um durch Änderung der Orientierung der Ablenkeinrichtung die Auslenkung des beleuchteten Feldes in der Objektebene zu erzielen.

Zur Abbildung von Transmissionselektronen auf den Detektor umfaßt das Untersuchungssystem eine Elektronenquelle und eine Blende, um aus den von der Quelle emittierten Elektronen einen Strahl zu formen, der das Feld in der Objektebene ausleuchtet. Ferner ist eine zweite Deflektoreinrichtung vorgesehen, um den Elektronenstrahl quer zu seiner Strahlrichtung auszulenken und damit die Verlagerung des beleuchteten Feldes in der Objektebene zu erreichen. Die erste Deflektoreinrichtung und der Detektor sind dann auf einer der Quelle bezüglich der Objektebene gegenüberliegenden Seite des Objekts angeordnet, um die durch das Objekt hindurchtretenden Transmissionselektronen zu erfassen.

Zur Erfassung von Rückstreuelektronen bzw. Sekundärelektronen sind die Quelle und der Detektor auf einer bezüglich der Objektebene gleichen Seite des Objekts angeordnet. Vorzugsweise wird dann die erste Deflektoreinrichtung nicht nur dazu eingesetzt, den Bereich, von dem austretende Elektronen auf den Detektor abgebildet werden, in der Objektebene zu verlagern, sondern auch dazu, das durch die von der Quelle austretenden Elektronen beleuchtete Feld in der Objektebene zu verlagern. Die erste Deflektoreinrichtung wird dann von dem von der Quelle zum Objekt verlaufenden Elektronenstrahl in die eine Richtung und von dem von dem Objekt zum Detektor verlaufenden Elektronenstrahl in die andere Richtung durchsetzt. Hierbei weisen die von der Quelle zum Objekt verlaufenden Elektronen im allgemeinen eine größere kinetische Energie auf als die von dem Objekt zum Detektor verlaufenden Elektronen. Die Deflektoreinrichtung ist dabei vorzugsweise derart ausgebildet, daß sie für die in beide Richtungen verlaufenden Elektronen einen jeweils im wesentlichen gleichen Ablenkwinkel bereitstellt.

Hierzu sieht die Erfindung als Deflektoreinrichtung eine Ablenkvorrichtung vor, welche in einem räumlichen Volumen ein elektrisches und ein magnetisches Ablenkfeld bereitstellt, wobei die Bewegungsrichtungen der Elektronen und die Feldrichtungen des elektrischen und magnetischen Feldes jeweils paarweise in etwa orthogonal zueinander orientiert sind.

Das elektrische Ablenkfeld kann beispielsweise durch eine Elektrodenanordnung bereitgestellt sein, und das magnetische Ablenkfeld kann beispielsweise durch eine Stromleiterwindungsanordung bereitgestellt sein. Es ist dann erfindungsgemäß eine Steuerung vorgesehen, welche Ströme durch die Stromleiterwindungsanordnung und an die Elektrodenanordnung angelegte Spannungen derart einstellt, daß die von der Quelle zum Objekt verlaufenden Elektronen und die von dem Objekt zu dem Detektor verlaufenden Elektronen sich auf im wesentlichen gleichen oder ähnlichen Trajektorien bewegen.

Im Hinblick auf eine präzise Ablenkung der sich in entgegengesetzte Richtungen durch die Ablenkvorrichtung bewegenden Elektronen ist die Ablenkvorrichtung gemäß einem weiteren Aspekt der Erfindung derart ausgebildet, daß sie eine Mehrzahl von mit axialem Abstand voneinander angeordneten Ringen aus einem Material mit hoher magnetischer Permeabilität umfaßt und die Stromleiterwindungen jeweils wenigstens einen der Ringe umgreifen. Das Material hoher magnetischer Permeabilität ist hierbei ein Material, dessen Permeabilität wesentlich größer als die des Vakuums ist.

Im Hinblick auf eine Vermeidung von Wirbelströmen ist dieses Material vorzugsweise elektrisch im wesentlichen nicht leitend bzw. ein elektrischer Isolator. Ein Beispiel für ein solches Material ist ein Ferrit.

Die Elektroden der Elektrodenanordnung sind vorzugsweise radial innerhalb der Ringe und der auf diese gewickelten Stromleiterwindungen angeordnet. Bei einer Führung der geladenen Teilchen im Vakuum ist gemäß einer bevorzugten Ausgestaltung vorgesehen, die Stromleiterwindungsanordnung außerhalb eines entsprechenden Vakuummantels und die Elektrodenanordnung radial innerhalb des Vakuummantels anzuordnen.

Zur Änderung der durch die Ablenkvorrichtung für die Elektronen bereitgestellten Ablenkwinkel ändert die Steuerung die Stärken sowohl des elektrischen als auch des magnetischen Feldes in dem Ablenkvolumen. Hierbei erfolgt die Änderung der Feldstärken vorzugsweise derart, daß das Verhältnis zwischen der Stärke des magnetischen Feldes und der Stärke des elektrischen Feldes unabhängig von dem Ablenkwinkel konstant ist. Vorzugsweise ist dieses Verhältnis im wesentlichen gleich der Differenz der Geschwindigkeiten der von der Quelle zum Objekt und der vom Objekt zum Detektor verlaufenden Elektronen, wenn diese die Ablenkvorrichtung passieren, geteilt durch das Produkt dieser beiden Geschwindigkeiten.

Ausführungsformen der Erfindung werden nachfolgend anhand von Zeichnungen näher erläutert. Hierbei zeigt:

Figur 1    eine schematische Darstellung einer Ausführungsform des erfindungsgemäßen Untersuchungssystems, bei dem Sekundärelektronen beobachtet werden,

Figur 2    eine schematische Darstellung zur Funktion einer Ausführungsform einer erfindungsgemäßen Ablenkvorrichtung, die auch in dem Untersuchungssystem der Figur 1 einsetzbar ist,

Figur 3    eine perspektivische Darstellung der in Figur 2 erläuterten Ablenkvorrichtung,

Figur 4    eine Darstellung der Anordnung von Stromleiterwindungen bei der in Figur 3 gezeigten Ablenkvorrichtung,

Figur 5    eine räumliche aufgebrochene Darstellung einer bei dem Untersuchungssystem der Figur 1 einsetzbaren Fokussierlinse,

Figur 6    eine schematische Darstellung zur Erläuterung der Fokussierlinse der Figur 5,

Figur 7    eine Variante der in den Figuren 5 und 6 gezeigten Fokussierlinse,

Figur 8    eine weitere Variante der in Figuren 5 und 6 gezeigten Fokussierlinse,

Figur 9    einen durch die Fokussierlinse der Figur 7 bereitgestellten Potentialverlauf,

Figur 10    eine Detaildarstellung der Fokussierlinse der Figur 7,

Figur 11    ein Ansteuerschema für die Fokussierlinse der Figur 7,

Figur 12    eine schematische Darstellung einer weiteren Ausführungsform des erfindungsgemäßen Untersuchungssystems, bei dem Rückstreuelektronen beobachtet werden,

Figur 13    eine schematische Darstellung einer Variante der in Figur 12 dargestellten Ausführungsform,

Figur 14    eine schematische Darstellung einer weiteren Ausführungsform des erfindungsgemäßen Untersuchungssystems, bei dem Transmissionselektronen beobachtet werden,

Figur 15    eine schematische Darstellung einer Variante des in Figur 14 dargestellten Untersuchungssystems und

Figur 16    eine schematische Darstellung einer weiteren Ausführungsform des erfindungsgemäßen Untersuchungssystems, bei dem Photoelektronen beobachtet werden.

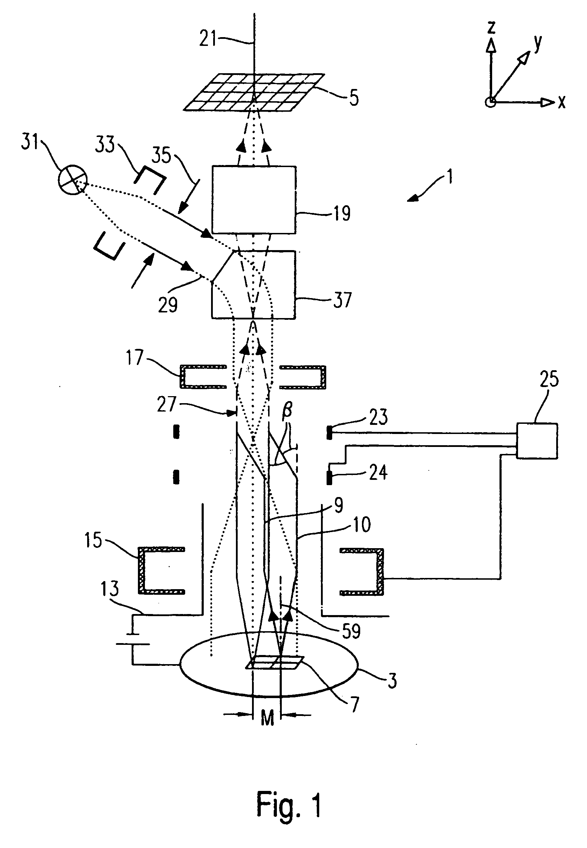

Figur 1 zeigt in schematischer Darstellung eine erste Ausführungsform eines erfindungsgemäßen Untersuchungssystems 1. Das Untersuchungssystem 1 dient zur Abbildung von Strukturen eines Objekts 3, wie etwa eines Halbleiterwafers 3 oder anderer miniaturisierter Strukturen, wie beispielsweise einer Lithographiemaske oder auch etwa einer biologischen Probe. Die Strukturen des Objekts 3 werden untersucht, indem von dem Objekt 3 austretende Sekundärelektronen auf einen ortsauflösenden Detektor 5 abgebildet werden. Der Detektor 5 ist zweidimensional ortsauflösend, indem er eine Vielzahl von Bildpunkten (Pixeln) aufweist, die in einer zweidimensionalen Matrix angeordnet sind. Ein jeder Bildpunkt sammelt auslesbare Information, die eine in einem Belichtungszeitintervall auf den Bildpunkt treffende Elektronenintensität repräsentiert.

Bei dem Detektor handelt es sich dabei bevorzugt um ein Bauelement, welches in der Lage ist, eine Intensitätsverteilung von auf eine Detektionsfläche auftreffenden geladenen Teilchen zweidimensional ortsaufgelöst zeitlich zu integrieren. Die auf diese Weise detektierte Information kann zur Weiterverarbeitung an eine externe Verarbeitungsvorrichtung, die beispielsweise auch Teil einer das gesamte System steuernden Steuerung sein kann, ausgegeben werden. Insbesondere kann es sich bei dem Detektor um einen oder mehrere CCD-Chips handeln.

Zwischen dem Objekt 3 und dem Detektor 5 sind elektronenoptische Komponenten vorgesehen, welche ein räumlich begrenztes rechteckiges Feld 7 in der Ebene des Objekts 3 auf den Detektor 5 abbilden. Die Abbildung erfolgt dabei derart, daß an verschiedenen Orten des Feldes 7 austretende Sekundärelektronen auf verschiedene Pixel des Detektors 5 treffen. Somit können über den Detektor 5 Strukturen des Objekts 3, die sich hinsichtlich der Intensität an emittierten Sekundärelektronen unterscheiden, bildlich dargestellt werden.

In Figur 1 sind die Trajektorien 9, 10 von zwei Sekundärelektronen, die von einem Ort des Feldes 7 unter verschiedenen Winkeln austreten symbolisch dargestellt. Die mit einer kinetischen Energie zwischen 0eV und etwa 5eV aus dem Objekt 3 austretenden Sekundärelektronen werden zunächst auf eine kinetische Energie von etwa 20keV beschleunigt. Die Beschleunigung erfolgt durch ein elektrisches Feld, welches zwischen dem Objekt 3 und einer vor dem Objekt angeordneten Elektrode 13 bereitgestellt ist. Nach der Beschleunigung durchlaufen die Elektronen ein Fokussierlinsenduplett, das eine objektnahe Fokussierlinse 15 und eine weitere Fokussierlinse 17 umfaßt. Die Elektrode 13 wirkt hierbei mit der objektnahen Fokussierlinse 15 zusammen und bildet mit dieser eine erste Fokussiereinheit des Dupletts, dessen zweite Fokussiereinheit durch die weitere Fokussierlinse 17 gebildet ist.

Nach Durchlaufen des Dupletts erfolgt eine Bildvergrößerung in einer schematisch dargestellten Nachvergrößerungsoptik 19, die ein oder mehrere teilchenoptische Linsen und andere Komponenten enthalten kann, bevor die Elektronen auf den Detektor 5 treffen.

Die Fokussierlinsen 15, 17, die Nachvergrößerungsoptik 19 und der Detektor 5 sind bezüglich einer Hauptachse 21 des Untersuchungssystems zentriert. Allerdings ist das Feld 7, das elektronenoptisch auf den Detektor 5 abgebildet ist, bezüglich der Hauptachse 21 in einer x-Richtung quer zur Hauptachse 21 verlagerbar. Hierzu sind zwischen den beiden Fokussierlinsen 15 und 17 zwei Deflektoren 23 und 24 angeordnet. In Figur 1 ist eine Situation dargestellt, bei der das Zentrum des auf den Detektor 5 abgebildeten Feldes 7 um eine Strecke M in x-Richtung von der Hauptachse 21 weg verlagert ist. Nach Durchlaufen der objektnahen Fokussierlinse 15 erstrecken sich die Trajektorien der Elektronen parallel zur z-Achse bzw. Hauptachse 21. Der näher am Objekt 3 angeordnete Deflektor 24 bewirkt eine Ablenkung der Trajektorien um einen Winkel β derart, daß die Elektronen in Richtung zur Hauptachse 21 hin verlaufen. Daraufhin bewirkt der entfernter von dem Objekt 3 angeordnete Deflektor 23 eine Ablenkung der Elektronen um einen Winkel -β derart, daß die Elektronen wieder parallel zur z-Achse weiterverlaufen. Die Auslenkung M des Feldes 7 weg von der Hauptachse 21 ist somit durch den Abstand der beiden Deflektoren 23, 24 voneinander und den durch die beiden Deflektoren 23, 24 jeweils bereitgestellten Ablenkwinkel β gegeben.

Es ist ferner eine Steuerung 25 vorgesehen, die die Deflektoren 23 und 24 ansteuert, um den Ablenkwinkel β und damit die Auslenkung M des Feldes 7 weg von der Hauptachse 21 einzustellen. Die Winkel β werden dabei derart eingestellt, daß die Sekundärelektronen nach Durchlaufen des entfernt von dem Objekt 3 angeordneten Deflektors 23 einen von der Auslenkung M unabhängigen und fest bezüglich des Untersuchungssystems positionierten Strahlquerschnitt durchlaufen. Dieser von der Auslenkung M unabhängige Strahlquerschnitt ist in Figur 1 mit dem Bezugszeichen 27 gekennzeichnet und ist bezüglich der Hauptachse 21 zentriert. Nach Durchsetzen des mit dem Bezugszeichen 27 gekennzeichneten von der Auslenkung unabhängigen Strahlquerschnitts verlaufen die Elektronen in einem ebenfalls von der Auslenkung M unabhängigen Strahlengang weiter zum Detektor. In der in der Figur 1 gezeigten Ausführungsform ist dieser weitere Strahlenverlauf hin zum Detektor ebenfalls bezüglich der Hauptachse 21 zentriert. Es ist allerdings möglich, hier auch Strahlablenker und andere Komponenten, wie etwa Energiefilter, vorzusehen, die den Strahl zwischen dem von der Auslenkung unabhängigen Querschnitt 27 und dem Detektor 5 von der Hauptachse 21 wegführen.

Um aus dem Objekt 3 in dem auf den Detektor 5 abgebildeten Feld 7 Sekundärelektronen herauszulösen, wird dieses Feld 7 mit Primärelektronen beleuchtet. Ein Primärelektronenstrahl 29 wird von einer Elektronenkanone 31, einer Magnetlinse 33 und einer Strahlformungsblende 35 geformt. Die kinetische Energie der Primärelektronen des Strahls 29 beträgt etwa 22keV.

Der Primärelektronenstrahl 29 wird mittels eines Strahlkombinators 37 mit dem zum Detektor 5 hin verlaufenden Sekundärelektronenstrahl überlagert. Der Strahlkombinator 37 ist im Strahlengang der Sekundärelektronen zwischen der Fokussierlinse 17 und der Nachvergrößerungsoptik 19 angeordnet und wird von den Sekundärelektronen geradlinig durchsetzt. Die schräg zur Hauptachse 21 in den Strahlkombinator 37 eintretenden Primärelektronen 29 lenkt der Strahlkombinator 37 derart ab, daß sich die Primärelektronen nach Durchlaufen des Strahlkombinators 37 entlang der Hauptachse 21 in Richtung hin zu dem Objekt 3 bewegen.

Nach dem Strahlkombinator 37 durchlaufen die Primärelektronen die Fokussierlinse 17 und den von der Auslenkung M unabhängigen Strahlquerschnitt 27 und sodann den Deflektor 23, der sie um einen Winkel β weg von der Hauptachse 21 lenkt. Anschließend werden die Primärelektronen von dem Deflektor 24 um einen Winkel -β hin zur Hauptachse 21 gelenkt, so daß sie schließlich wieder parallel zur Hauptachse 21 verlaufen, wobei allerdings der Primärelektronenstrahl durch die beiden Deflektoren 23, 24 ebenfalls um die Strecke M von der Hauptachse 21 weg verlagert wurde. Die Primärelektronen durchlaufen sodann die Fokussierlinse 15 und werden durch das von der Elektrode 13 bereitgestellte elektrische Feld auf eine kinetische Energie von etwa 2keV abgebremst, bevor sie in dem Feld 7 auf das Objekt 3 treffen und dort die Sekundärelektronen herauslösen.

Der hier angegebene Wert der kinetischen Energie von etwa 2keV zur Erzeugung der Sekundärelektronen ist ein beispielhafter Wert. Es können die Primärelektronen auch auf andere Energien abgebremst werden, beispielsweise auf Energien in einem Bereich von 100eV bis 5keV.

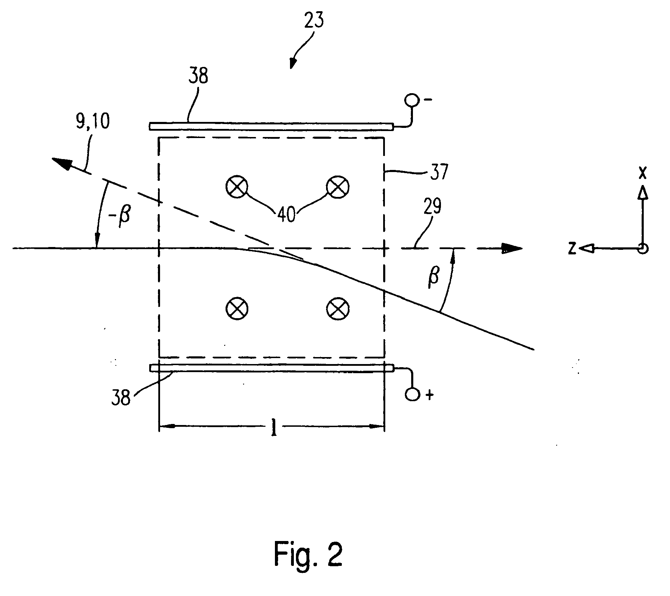

Die Deflektoren 23, 24 stellen zusammen für sowohl die Primärelektronen als auch für die Sekundärelektronen eine gleiche Verlagerung M quer zur z-Achse bzw. Hauptachse 21 bereit. Hierzu weisen die beiden Deflektoren 23, 24 zueinander symmetrischen Aufbau und Wirkungsweise auf, welche in den Figuren 2 bis 4 erläutert sind.

In der Darstellung der Figur 2 treten die Primärelektronen 29 von links in den Deflektor 23 ein, und die Sekundärelektronen 9, 10 treten von rechts in den Deflektor ein. Der Deflektor 23 stellt in einem Volumen 37 ein durch Elektroden 38 erzeugtes elektrisches Feld sowie ein magnetisches Feld bereit, welches durch Symbole 40 gekennzeichnet ist. Die Richtungen des elektrischen Feldes und des magnetischen Feldes sind zueinander und zur z-Richtung orthogonal ausgerichtet.

Nach Durchlaufen des Deflektors 23 weist die Bewegungsrichtung der Elektronen bezüglich ihrer Bewegungsrichtung vor Eintritt in den Deflektor einen Winkel β auf, der bei nichtrelativistischer Rechnung gegeben ist durch die folgende Gleichung:

$$\beta = \frac{e \cdot l \cdot \left(E_x - B_y \cdot V_z\right)}{m V_z^2},$$

wobei

e     die Elementarladung
m     die Elektronenmasse
l     die Länge des Feldvolumens 37 in z-Richtung
$E_x$     die Stärke des elektrischen Feldes,
By     die Stärke des magnetischen Feldes und
$V_z$     die Geschwindigkeit der Elektronen in z-Richtung

angibt.

Die Ablenkwinkel β bzw. -β für die Primärelektronen und die Sekundärelektronen sind dann gleich wenn die elektrische Feldstärke und die magnetische Feldstärke in etwa die folgende Relation erfüllen:

$$B(E_x) = \frac{V_{z1} - V_{z2}}{V_{z1} \cdot V_{z2}} \cdot E_x,$$

wobei

$V_{z1}$     die Geschwindigkeit der Primärelektronen und
Vz2     die Geschwindigkeit der Sekundärelektronen

angibt.

Die oben angegebene Relation zwischen den elektrischen und magnetischen Feldstärken gilt näherungsweise. Bei Berücksichtigung von relativistischen Termen und Termen höherer Ordnung, die beispielsweise bei der Berücksichtigung von Rand- bzw. Streufeldern des elektrischen bzw. des magnetischen Feldes entstehen, können Abweichungen hiervon auftreten.

Bei dieser Wahl des Verhältnisses zwischen den elektrischen und magnetischen Feldstärken ist es somit möglich, daß die Primärelektronen und die Sekundärelektronen von dem Deflektor 23 um entgegengesetzt gleiche Winkel abgelenkt werden und sich deren Trajektorien somit decken.

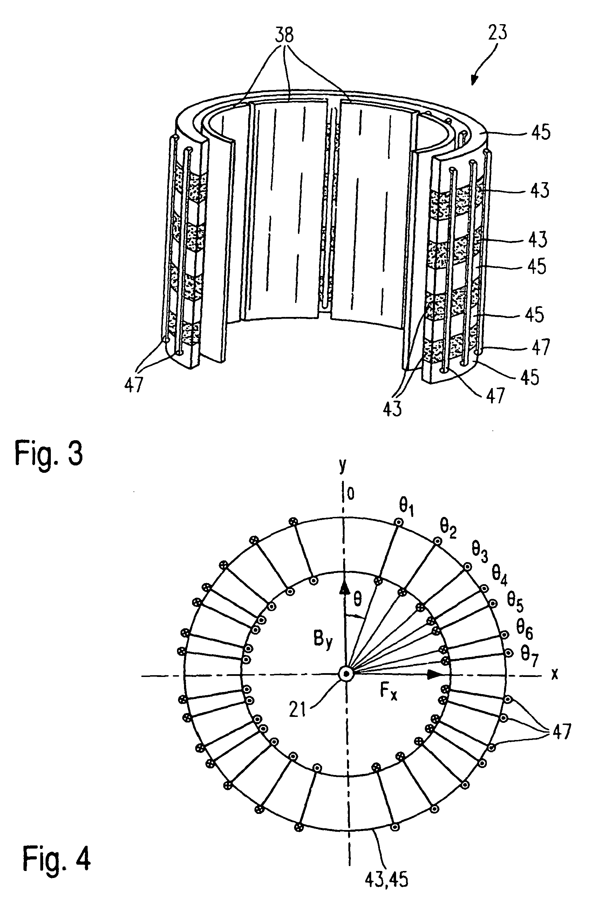

Die Deflektoren 23, 24 weisen jeweils einen oder mehrere Ferritringe 43 und Keramikringe 45 gleichen Durchmessers auf, welche zentrisch zur Hauptachse 21 alternierend aufeinandergestapelt sind, wobei die Enden des Stapels in z-Richtung jeweils durch einen Keramikring 45 gebildet sind. Die an den Enden des Stapels angeordneten Keramikringe 45 weisen jeweils eine Mehrzahl in Umfangsrichtung der Ringe verteilt angeordnete Bohrungen zum Durchtritt von Stromleiterwindungen 47 auf. Eine jede Stromleiterwindung 47 erstreckt sich parallel zur Hauptachse 21 und umgreift mehrere der Ferritringe 43. Eine Verteilung der Stromleiterwindungen 47 in Umfangsrichtung der Ringe 43, 45 ist aus Figur 4 ersichtlich. Die hierbei auftretenden Winkel $\theta_1$ bis $\theta_7$ haben folgende Werte: $\theta_1$=21,6°, $\theta_2$=41,6°, $\theta_3$=47,6°, $\theta_4$=62,4°, $\theta_5$=68,4°, $\theta_6$=78,5° und $\theta_7$=84,5°. Diese Winkel sind derart gewählt, daß das durch die Stromleiterwindungen 47 erzeugte Magnetfeld ein im wesentlichen homogenes in y-Richtung orientiertes Magnetfeld ist.

Radial innerhalb der Ringe 43, 45 und der Windungen 47 sind acht gleichmäßig um den Umfang verteilt angeordnete teilzylindrische Elektroden 38 angeordnet, an welche Spannungen derart angelegt werden können, daß sie das im wesentlichen homogene und in x-Richtung orientierte elektrische Feld in dem Volumen 37 bereitstellen.

Mit den Elektroden 38 kann ebenfalls eine Ablenkung des Strahls in y-Richtung erzeugt werden, um das beleuchtete Feld auf dem Objekt auch geringfügig in y-Richtung auszulenken, wie dies nachfolgend noch erläutert wird.

Die Steuerung 25 stellt die an die Elektroden 38 angelegten Spannungen und die die Windungen 47 durchfließenden Ströme derart ein, daß das in dem Volumen 37 erzeugte elektrische Feld und das dort erzeugte magnetische Feld die oben genannte Relation erfüllen.

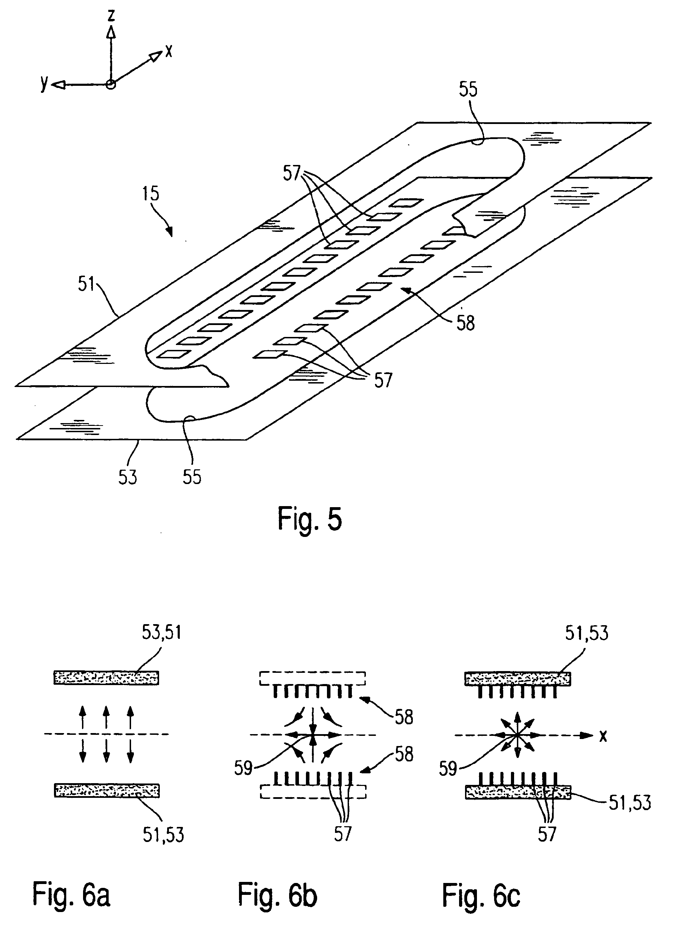

Die dem Objekt nahe Fokussierlinse 15 ist in Figur 5 perspektivisch und schematisch dargestellt. Diese umfaßt zwei jeweils ebene Blendenelektroden 51, 53, welche orthogonal zur z-Richtung orientiert und mit Abstand in z-Richtung voneinander angeordnet sind. Eine jede der Blendenelektroden 51, 53 weist einen sich in x-Richtung erstreckenden Schlitz 55 auf, durch welchen die Primärelektronen und die Sekundärelektronen hindurchtreten. Liegt an den Elektroden 51, 53 eine elektrische Spannung an, erzeugen diese jeweils ein elektrisches Feld mit einem Feldlinienverlauf, wie er in Figur 6a schematisch dargestellt ist. Ein solches elektrisches Feld wirkt auf die die Elektroden 51, 53 durchsetzenden Elektronen wie eine Zylinderlinse.

In z-Richtung zwischen den beiden Elektroden 51, 53 sind zwei parallel mit Abstand voneinander angeordnete Reihen von Fingerelektroden 57 vorgesehen, wobei sich die Reihen in x-Richtung erstrecken und wobei die Primärelektronen und die Sekundärelektronen zwischen den beiden Reihen hindurchtreten. Die Gesamtheit der Fingerelektroden 57 bildet eine nachfolgend als Kammelektrode 58 bezeichnete Elektrodenanordnung. An eine jede Fingerelektrode 57 kann, gesteuert durch die Steuerung 25, eine separat einstellbare Spannung angelegt werden. Es wird dabei an die Fingerelektroden 57 ein Spannungsmuster derart angelegt, daß das durch die Fingerelektroden 57 erzeugte elektrische Feld in etwa Quadrupolsymmetrie aufweist, wie dies in Figur 6b dargestellt ist. Durch entsprechende Ansteuerung der Fingerelektroden 57 kann durch die Steuerung 25 eine Hauptachse 59 des Quadrupolfeldes in x-Richtung verlagert werden.

Auf die die Fokussierlinse 15 durchsetzenden Elektronen wirkt somit eine Überlagerung des Zylinderlinsenfelds gemäß Figur 6a und des Quadrupolfelds gemäß Figur 6b. Diese Überlagerung der elektrischen Felder entspricht einem Rundlinsenfeld mit einer Symmetrieachse 59, wie dies in Figur 6c schematisch dargestellt ist.

Dies bedeutet, daß die Linse 15 auf die diese durchsetzenden Elektronen eine Wirkung wie eine fokussierende Rundlinse hat. Hierbei ist allerdings über die Steuerung 25 die Symmetrieachse 59 des Rundlinsenfeldes in x-Richtung verlagerbar.

Im Betrieb legt die Steuerung 25 an die Fingerelektroden 57 ein derartiges Spannungsmuster an, daß die Symmetrieachse 59 des Rundlinsenfeldes um den gleichen Betrag M von der Hauptachse 21 weg verlagert ist, wie das Zentrum des auf den Detektor 5 abgebildeten Feldes 7 des Objekts 3. Hierdurch ist die Wirkung der Fokussierlinse 15 auf die aus dem Feld 7 austretenden Sekundärelektronen von der Auslenkung M des beleuchteten Felds 7 im wesentlichen unabhängig. Hierdurch werden Abbildungsfehler, wie sie herkömmliche Rundlinsenfelder für entfernt von der Symmetrieachse des Rundlinsenfeldes verlaufende Strahlengänge erzeugen, weitgehend vermieden.

Die im Zusammenhang mit den Figuren 5 und 6 erläuterte Linse 15 kann auch in anderen Anwendungen eingesetzt werden, die von elektronenmikroskopischen Anwendungen verschieden sind. Es können dies sämtliche Anwendungen sein, in denen auf einen Strahl geladener Teilchen, die insbesondere auch Ionen umfassen, eine fokussierende oder/und ablenkende Wirkung ausgeübt werden soll, wobei ein Achszentrum dieser fokussierenden Wirkung quer zur Strahlrichtung verlagerbar ist. Es sind dies beispielsweise auch Anwendungen in Lithographieverfahren, wo Strukturen einer Maske auf eine strahlungsempfindliche Schicht mittels geladener Teilchen übertragen werden. Auch sind solche Anwendungen ins Auge gefaßt, bei denen entlang der Schlitzrichtung an mehreren mit ausreichendem Abstand voneinander angeordneten Orten Quadrupolfelder durch die Kammblende erzeugt werden, so daß an mehreren Stellen eine fokussierende Wirkung ausgeübt werden kann. Die Linse kann damit mehrere voneinander beabstandete Strahlen geladener Teilchen gleichzeitig fokussieren.

Hierbei können an den Blendenelektroden 51 und 53 insbesondere gleiche Potentiale anliegen, so daß die geladenen Teilchen vor und nach ihrem Durchtritt durch die Linse gleiche kinetische Energie in z-Richtung aufweisen. Es ist jedoch auch möglich, die beiden Blendenelektroden 51 und 53 auf unterschiedliches Potential zu legen, so daß die die Linse 15 durchlaufenden geladenen Teilchen durch die Linse beschleunigt oder verzögert werden. In beiden Fällen ist es möglich, daß die vier Elektroden im Mittel, d.h. abgesehen von dem Quadrupolpotential, das sie bereitstellen, ein Potential aufweisen, das gleich dem Potential der Blendenelektrode 51 oder/und der Blendenelektrode 53 ist, oder daß die Fingerelektroden 57 ein mittleres Potential bereitstellen, das von dem Potential der Blendenelektroden 51 und 53 verschieden ist und das insgesamt insbesondere höher ist als das höchste der beiden Blendenelektroden 51, 53 und das auch niedriger sein kann als das niedrigste Potential der beiden Blendenelektroden 51, 53.

In der im Zusammenhang mit Figur 1 erläuterten Anwendung ist die Linse 15 mit ihrer Anordnung aus Blendenelektroden und Fingerelektroden unmittelbar vor dem Objekt 3 angeordnet. Es ist hier dann wünschenswert, wenn die Linse 15 neben ihrer fokussierenden Funktion auch die Funktion der Beschleunigung der vom Objekt 3 austretenden Sekundärelektronen bzw. der entsprechenden Verzögerung der Primärelektronen übernimmt. In einem solchen Fall wirkt die Linse 15 dann als Immersionslinse und ihre Blendenelektroden 51 und 53 müssen auf unterschiedlichem elektrischen Potential liegen. Ferner ist es hierbei wünschenswert, wenn zwischen dem Objekt 3 und der dem Objekt zuweisenden Blendenelektrode 53 bereits ein gewisser Potentialunterschied besteht, so dass die teilweise mit sehr niedriger kinetischer Energie aus dem Objekt 3 austretenden Sekundärelektronen bereits auf ihrem Weg zur Linse 15 hin beschleunigt werden (Absaugen der Sekundärelektronen). Da hierbei allerdings das die zunächst langsamen Sekundärelektronen beschleunigende elektrische Feld vornehmlich durch die dem Objekt zugewandte Blendenelektrode 53 bereitgestellt wird, wirkt das in y-Richtung fokussierende Zylinderlinsenfeld der Blendenelektrode 53 intensiver auf die zunächst langsamen Elektronen als das in x-Richtung fokussierende Quadrupolfeld der Fingerelektroden 57 nachfolgend auf die dann bereits schnelleren Elektronen wirkt. Somit wird beim Betrieb der in Figur 5 gezeigten Linse 15 als Immersionslinse die kombinierte Wirkung des Zylinderlinsenfeldes und des Quadrupolfeldes derart, daß diese beiden Felder insgesamt von dem die Linse durchsetzenden Teilchenstrahl als Rundlinse erfahren werden, gestört.

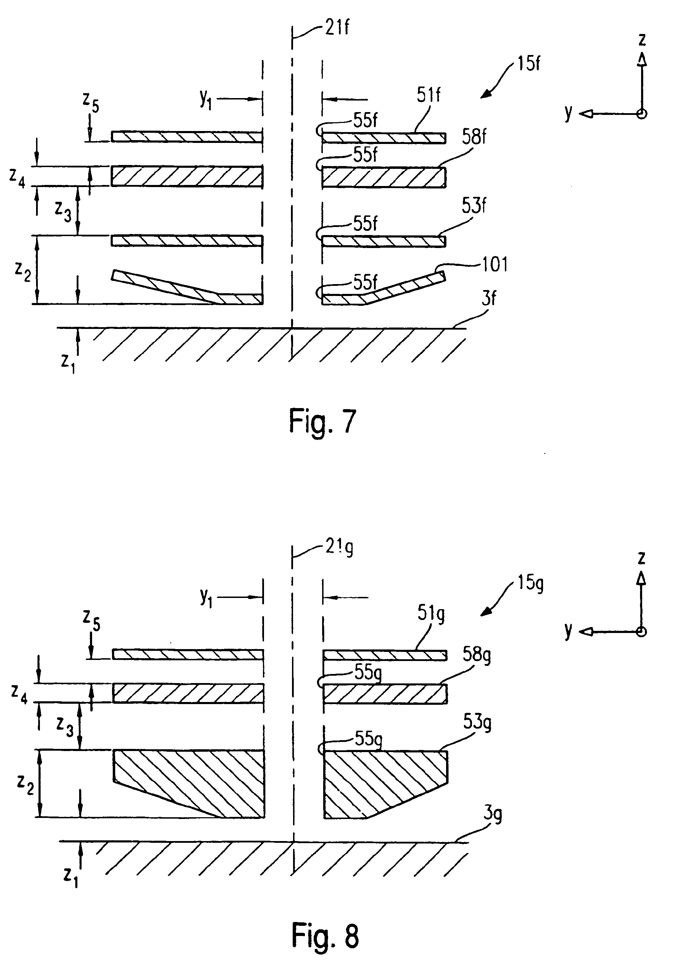

Varianten der in Figur 5 gezeigten Fokussiereinrichtung, die dieser Problematik zur Erzielung einer präziseren Rundlinsenwirkung Rechnung tragen, sind in den Figuren 7 und 8 im Schnitt schematisch dargestellt. Deren Komponenten, die hinsichtlich Funktion und Aufbau den Komponenten der Figur 5 entsprechen, sind mit den gleichen Bezugsziffern wie in Figur 5 bezeichnet, zur Unterscheidung jedoch mit einem zusätzlichen Buchstaben versehen.

Eine in Figur 7 gezeigte Fokussierlinse 15f umfasst zwei mit Abstand in z-Richtung voneinander angeordnete Blendenelektroden 51f und 53f sowie eine Kammlinse 58f mit einer Vielzahl von in Figur 7 nicht dargestellten Fingerelektroden. Zwischen der dem Objekt 3f nahen Blendenelektrode 53f und dem Objekt ist eine weitere Blendenelektrode 101 angeordnet. Sämtliche der Elektroden 51f, 58f, 53f und 101 weisen in ihrem Zentrum eine langgestreckte Öffnung bzw. einen Schlitz 55f für den Durchtritt der Primär- bzw. Sekundärelektronen auf. In y-Richtung, d.h. quer zur Erstreckungsrichtung der Schlitze 55f, weisen sie eine Breite $y_1$ von beispielsweise 4 mm auf. In x-Richtung, d.h. in Erstreckungsrichtung der Schlitze 55f weisen diese eine Länge von beispielsweise 50 mm auf. Bei einem derart dimensionierten Ausführungsbeispiel weist die dem Objekt 3 nahe Blendenelektrode 101 in ihrem öffnungsnahen Bereich einen Abstand $z_1$ von dem Objekt 3f von 2 mm auf und liegt gegenüber dem Objekt 3f auf einem elektrischen Potential von 1 kV. Die in z-Richtung der Blendenelektrode 101 nachfolgende Blendenelektrode 53f weist in ihrem öffnungsnahen Bereich von dieser einen Abstand $z_2$ in z-Richtung von 4 mm auf und liegt auf einem elektrischen Potential von 15 kV. Die Kammlinse 58f weist von der Blendenelektrode 53f einen lichten Abstand $z_3$ von 5 mm auf und liegt auf einem elektrischen Potential von 20 kV. Ihre Fingerelektroden erstrecken sich in z-Richtung über eine Länge $z_4$ von 3 mm. Die vom Objekt 3f entfernt angeordnete Blendenelektrode 51f weist von der Kammelektrode 58f sodann einen lichten Abstand $z_5$ von 4 mm auf und liegt auf einem elektrischen Potential von 15 kV. Die Blendenelektroden 51f, 53f und 101 sind jeweils aus einem Blech einer Stärke von 0,5 mm gefertigt.

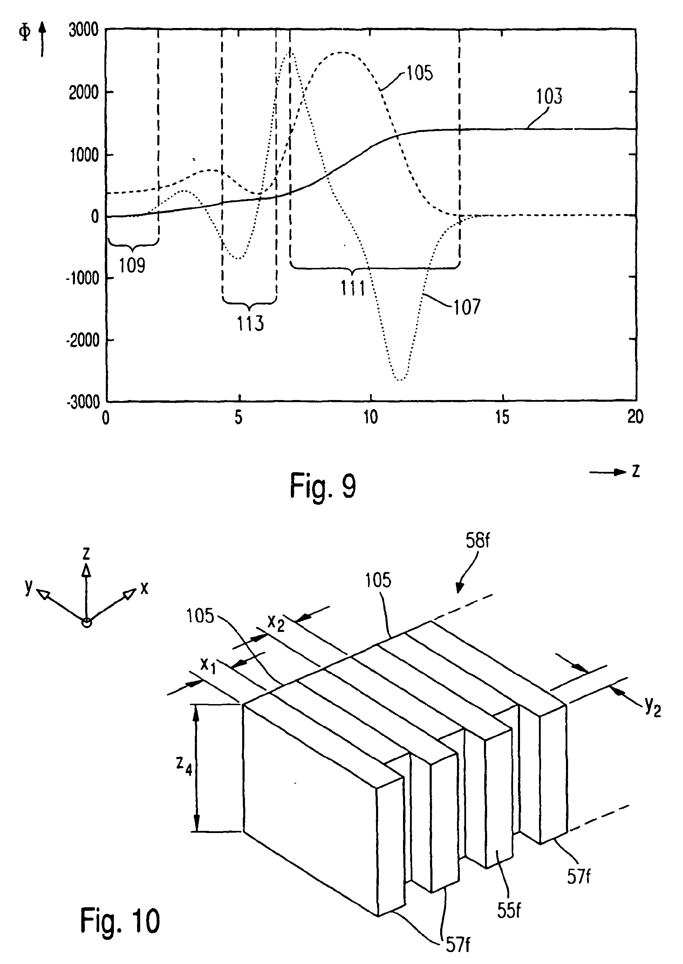

Figur 9 zeigt mit einer Kurve 103 den Verlauf des elektrischen Potentials, den die Linse 15f entlang der z-Achse, ausgehend von dem Objekt 3f, bereitstellt, in willkürlichen Koordinaten. In Figur 9 ist ferner als Kurve 105 die erste Ortsableitung des Potentialverlaufs 103 sowie als Kurve 107 die zweite Ortsableitung desselben eingetragen. In einem Bereich 109 steigt das Potential zunächst linear an, so daß die austretenden Sekundärelektronen gleichmäßig beschleunigt werden. In einem Bereich 111 im Zentrum der Linse 15f wirkt das fokussierende Zylinderlinsenfeld, wie dies aus dem nach oben gerichteten Bauch der ersten Ableitung 105 des Potentialverlaufs ersichtlich ist. Zwischen den Bereichen 109 und 111 stellen die Elektroden allerdings einen Bereich 113 bereit, in dem der Potentialverlauf 103 nicht stark ansteigt und ein Plateau bildet. In diesem Bereich 113 weist die erste Ableitung 105 des Potentialverlaufs einen nach unten hängenden Bauch auf, so daß dort auf die Elektronen ein defokussierendes Zylinderlinsenfeld wirkt. Dieses defokussierende Zylinderlinsenfeld dient dazu, die vorangehend geschilderte gesamte Zylinderlinsenwirkung gegenüber dem durch die Kammblende 58f bereitstellbaren Quadrupolfeld zu reduzieren, so daß das Gewicht zwischen der Gesamt-Zylinderlinsenwirkung und der Quadrupol-Linsenwirkung auch für den Fall des Betriebs der Linse 15f als Immersionslinse einer Rundlinsenwirkung nahekommt. Dieser günstige Feldverlauf geht bei der in Figur 7 in z-Richtung gezeigten Linse 15f auf die beiden mit Abstand voneinander angeordneten Elektroden 53f und 101 zurück.

Eine in Figur 8 dargestellte Fokussierlinse 15g weist einen Aufbau auf, der der in Figur 7 gezeigten Linse ähnlich ist. Im Unterschied hierzu ist jedoch keine zusätzliche objektnahe Blendenelektrode vorgesehen. Es ist vielmehr eine einer Kammlinse 58g in z-Richtung zu einem Objekt 3g nahe Blendenelektrode 53g nicht aus einem dünnen Blech gefertigt, sondern weist eine in der Schnittdarstellung der Figur 8 beidseits einer Öffnung 55g gezeigte Trapezgestalt mit erhöhter Dicke $z_2$ auf. Bei einer möglichen Auslegung der Ausführungsform der Linse 15g sind die in Figur 8 eingetragenen Abmessungen $z_1$, $z_2$, $z_3$, $z_4$, $z_5$ und $y_1$ gleich den entsprechenden Abmessungen der Figur 7. Hierbei liegt die dem Objekt 3g nahe Blendenelektrode 53g auf einem Potential von 1 kV, die Kammlinse 58g liegt auf einem mittleren Potential von 20 kV und eine vom Objekt 3g entfernte Blendenelektrode 51g liegt auf einem Potential von 15 kV.

Mit der verdickten objektnahen Blendenelektroden 53g kann ein ähnlich defokussierendes Zylinderlinsenfeld bereitgestellt werden, wie durch die beiden Elektroden 101 und 53f der in Figur 7 gezeigten Ausführungsform.

In Figur 10 ist eine Detaildarstellung der bei der Ausführungsform gemäß Figur 7 eingesetzten Kammblende 58f gezeigt. Fingerelektroden 57f sind als identische Platten ausgebildet, die in x-Richtung nebeneinander angeordnet sind, wobei einander benachbarte Fingerelektroden 57f durch Platten 105 aus keramischem Isolatormaterial 105 getrennt sind. Die Elektrodenplatten 57f weisen eine Dicke $x_1$ von 1 mm auf, während die Isolatorplatten 105 jeweils eine Dicke $x_2$ von 0,5 mm aufweisen. In z-Richtung erstrecken sich die Fingerelektrodenplatten 57f sowie die Isolatorplatten 105 über eine Höhe $z_4$ von 4 mm. In eine Richtung zur Öffnung 55f hin stehen die Elektrodenplatten 57f gegenüber den Isolatorplatten 105 in die Öffnung 55f hinein um eine Strecke $y_2$ von 2,5 mm vor.

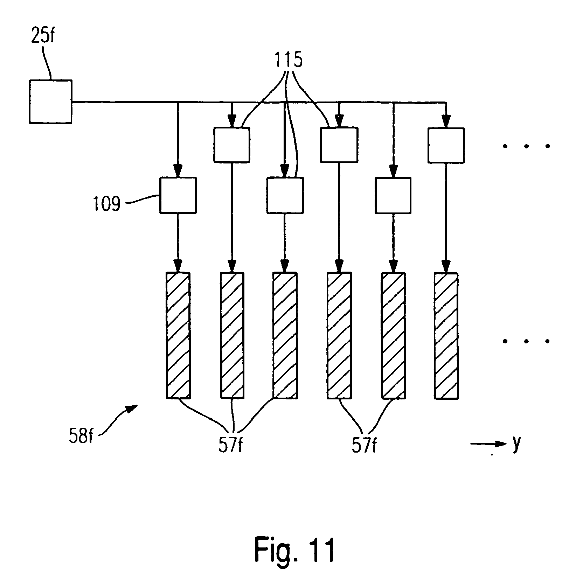

Die Figur 11 erläutert, wie an die Fingerelektroden der in den Figuren 7 und 8 dargestellten Ausführungsformen unterschiedliche Potentiale angelegt werden können, so daß die Kammblenden das Quadrupolfeld bereitstellen.

Bei der Ausführungform der Figur 11 ist einer jeden Fingerelektrode 57f ein eigener Treiber 109 zugeordnet, um an die jeweilige Fingerelektrode 57f eine gewünschte Spannung anzulegen. Die einzelnen Treiber 109 wiederum werden von einer übergeordneten Fokussierlinsensteuerung 25f angesteuert, um das durch die Treiber 109 erzeugte Spannungsmuster in x-Richtung zu verlagern, wenn die Rundlinsenwirkung im Betrieb der Linse 15f verlagert werden soll. Insbesondere ist diese Verlagerung des Quadrupolfeldes in x-Richtung durch stetige Änderung der an die Fingerelektroden angelegten Spannungen ebenfalls stetig möglich. Ferner kann die Verlagerung auch schrittweise erfolgen, in dem beispielsweise ein an die Fingerelektroden angelegtes gleichbleibendes Spannungsmuster von einer Fingerelektrodengruppe auf eine weitere Fingerelektrodengruppe weitergeschaltet wird.

Alternativ zu der im Zusammenhang mit den Figuren 5 bis 11 erläuterten Ausgestaltung der Fokussierlinse 15 kann auch die auf E. Goto zurückgehende Linse mit variabler Achse eingesetzt werden, wie dies vorangehend bereits erläutert wurde.

Aufgrund der unterschiedlichen kinetischen Energien bzw. Geschwindigkeiten der Primärelektronen und der Sekundärelektronen ist es möglich, daß durch die Deflektoren 23, 24 für beide Arten von Elektronen gleiche Ablenkwinkel β bzw. Auslenkungen M weg von der Hauptachse 21 bereitgestellt werden. Allerdings weist die Fokussierlinse 15 und auch die Fokussierlinse 17 für die beiden Arten von Elektronen aufgrund des Unterschieds in deren kinetischer Energie unterschiedliche fokussierende Wirkungen bzw. unterschiedliche Brennweiten auf. Dabei sind die Fokussierlinsen 15 und 17 dann derart angepaßt, daß sie im Hinblick auf eine fokussierende Wirkung für die Sekundärelektronen optimiert sind, um eine möglichst gute Auflösung der optischen Abbildung des Feldes 7 auf den Detektor 5 zu erreichen. Diese Anpassung der Fokussierlinsen 15 und 17 ist dann für die Primärelektronen zur Beleuchtung des Feldes 7 nicht optimal. Allerdings kann dies in Kauf genommen werden, da lediglich für die Beleuchtung des Feldes 7 eine präzise Abbildung beispielsweise der Blende 35 auf die Ebene des Objekts 3 nicht notwendig ist.

Mit dem Untersuchungssystem 1 kann ein räumliches Abbild von Strukturen des Objekts 3 folgendermaßen gewonnen werden. Die maximale Auslenkung M des Feldes weg von der Hauptachse 21 ist begrenzt durch die Länge des Schlitzes 55 in x-Richtung und durch den maximalen Strahlversatz, der durch die Deflektoren erzeugt werden kann. Es werden zunächst die Deflektoren 23, 24 und die Fokussierlinse 15 durch die Steuerung derart eingestellt, daß das in (-x)-Richtung maximal ausgelenkte Feld 7 auf den Detektor 5 abgebildet wird. Der Detektor 5 wird solange mit Sekundärelektronen belichtet, bis sich ein Bild mit ausreichendem Kontrast auslesen läßt, welches gespeichert wird. Sodann wird die Auslenkung M um einen Wert verringert, der der Ausdehnung des Feldes 7 in x-Richtung entspricht, und es wird eine erneute Aufnahme der Sekundärelektronen mit dem Detektor gewonnen, welche ebenfalls gespeichert wird. Dieser Vorgang wird schrittweise wiederholt, bis das Feld 7 mit seiner maximalen Auslenkung in (+x)-Richtung angeordnet ist. Sodann wird das Objekt 3 in y-Richtung relativ zu dem Untersuchungssystem mittels eines in den Figuren nicht dargestellten Antriebs mechanisch verlagert, und zwar um eine Strecke, die der Ausdehnung des Feldes 7 in y-Richtung entspricht. Daraufhin werden wiederum mit den jeweils verschiedenen Auslenkungen M Bilder mit der Kamera 5 aufgenommen. Wenn auf diese Weise die gesamte Oberfläche des Objekts abgetastet ist, werden die Bilder zusammengesetzt, um das räumliche Abbild der Strukturen des Objekts zu erhalten.

Es ist auch möglich, die Deflektoren 23, 24 derart auszubilden, daß sie neben der Auslenkung des Feldes 7 in x-Richtung auch eine Auslenkung des Feldes in y-Richtung erzeugen können. Hierbei ist die maximale Auslenkung in y-Richtung geringer als die maximale Auslenkung in x-Richtung, und zwar derart, daß bei den vergleichsweise geringen Auslenkungen in y-Richtung eine Abbildung ausreichender Qualität des beleuchteten Feldes 7 auf den Detektor erreicht wird. Es ist dann möglich, das Objekt 3 in y-Richtung kontinuierlich relativ zu dem Untersuchungssystem mechanisch zu verlagern und das beleuchtete Feld angepaßt an die mechanische Verlagerung des Objekts 3 relativ zum Untersuchungssystem mit dem bewegten Objekt in y-Richtung "mitzuführen".

Bei einem Primärelektronenstrom von $3,2\mu A$ und einer Ausdehnung des Feldes 7 in der Ebene des Objekts von $100\mu m \times 100\mu m$ kann ein Strom von etwa $2,6\mu A$ an Sekundärelektronen erzeugt werden. Hat die Kamera eine Auflösung von 1.000 mal 1.000 Pixeln, ergibt sich eine Ortsauflösung des Untersuchungssystems von 100nm. Sollen pro Aufnahme etwa 2.000 Elektronen auf jedes Pixel der Kamera treffen, so können mit dem Untersuchungssystem $0,2cm^2/sec$ bzw. $720cm^2/h$ der Objektoberfläche abgetastet werden.

Nachfolgend werden Varianten der Erfindung erläutert. Hierbei sind Komponenten, die hinsichtlich ihrer Funktion und ihres Aufbaues Komponenten der in den Figuren 1 bis 11 erläuterten Ausführungsformen entsprechen, mit den gleichen Bezugsziffern wie in den Figuren 1 bis 11 bezeichnet, zur Unterscheidung jedoch mit einem zusätzlichen Buchstaben versehen.

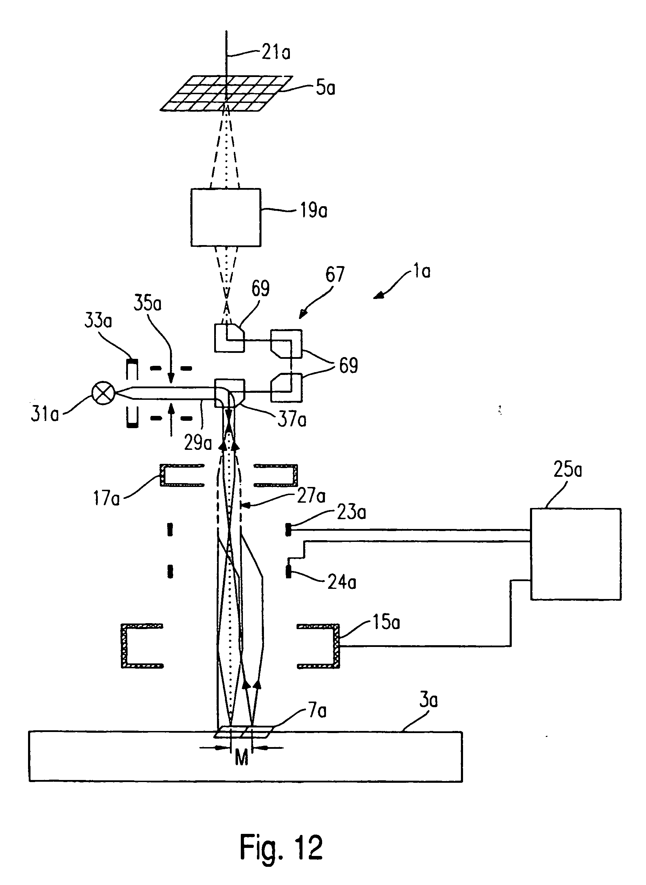

Ein in Figur 12 schematisch dargestelltes Untersuchungssystem 1a dient dazu, Rückstreuelektronen, die in einem Feld 7a aus einem zu untersuchenden Objekt 3a austreten, auf einen ortsauflösenden Detektor 5a abzubilden. Wie in der vorangehend beschriebenen Ausführungsform ist auch hier das auf den Detektor 5a abgebildete Feld 7a bezüglich einer Hauptachse 21a auslenkbar (Auslenkung M).

Da Rückstreuelektronen eine wesentlich größere kinetische Energie aufweisen als Sekundärelektronen, ist eine separate Elektrode zur Beschleunigung der Rückstreuelektronen (vergleiche Elektrode 13 in Figur 1) nicht unbedingt notwendig. Allerdings kann zur Erhöhung der kinetischen Energie der Rückstreuelektronen bei Bedarf auch eine entsprechende Elektrode vorgesehen sein.

Die Rückstreuelektronen durchlaufen nach Verlassen der Oberfläche des Objekts 3a zunächst eine dem Objekt nahe Fokussierlinse 15a, dann zwei Deflektoren 24a, 23a, deren Ablenkwinkel derart eingestellt sind, daß die von dem Feld 7a austretenden Rückstreuelektronen unabhängig von der Auslenkung M des Feldes 7a einen festen Strahlquerschnitt 27a durchlaufen. Nach Durchlaufen des festen Strahlquerschnitts 27a treten die Rückstreuelektronen durch eine weitere Fokussierlinse 17a und einen Strahlteiler bzw. Strahlkombinator 37a, der zur Überlagerung des Strahls Rückstreuelektronen mit einem Strahl Primärelektronen 29a dient, der durch eine Elektronenkanone 31a, einer Fokussierlinse 33a und einer Blende 35a geformt wird. Der Strom des Primärelektronenstrahls beträgt beispielsweise µ A, und die kinetische Energie beträgt beispielsweise 10keV.

Die Primärelektronen durchlaufen nach dem Strahlkombinator 37a nacheinander die Fokussierlinse 17a, die beiden Deflektoren 23a, 24a und die Fokussierlinse 15a. Dabei sind die Deflektoren 23a und 24a wiederum derart eingestellt, daß sie auch für die Primärelektronen eine solche Auslenkung M bereitstellen, daß der von den Primärelektronen beleuchtete Bereich auf dem Objekt 3a im wesentlichen mit dem auf den Detektor 5a abgebildeten Feld 7a zusammenfällt.

Da die Rückstreuelektronen eine relativ breite Energieverteilung aufweisen, ist zwischen dem Strahlkombinator 37a und einer Nachvergrößerungsoptik 19a ein abbildungserhaltendes Energiefilter 67 vorgesehen, um aus den Rückstreuelektronen Elektronen aus einem kleineren Energieband auszuwählen, die dann mit der Optik 19a vergrößert und auf den Detektor 5a abgebildet werden. Das Energiefilter 67 umfaßt mehrere Sektormagnete 69 und ist derart aufgebaut, daß die geometrische Abbildung des Feldes 7a auf den Detektor 5a durch das Filter 67 nicht gestört wird. Ein Beispiel für ein solches Energiefilter 67 ist in EP 0 218 920 B1 der Anmelderin beschrieben. Die Offenbarung dieser Schrift wird durch Inbezugnahme vollumfänglich in der vorliegenden Anmeldung aufgenommen.

Die dem Objekt 3a nahe Fokussierlinse 15a kann einen Aufbau haben, wie er in dem vorangehenden Ausführungsbeispiel im Zusammenhang mit den Figuren 5 bis 11 erläutert wurde. Es ist jedoch auch möglich, hierfür eine Linse mit variabler Achse einzusetzen, wie sie auf E. Goto zurückgeht.

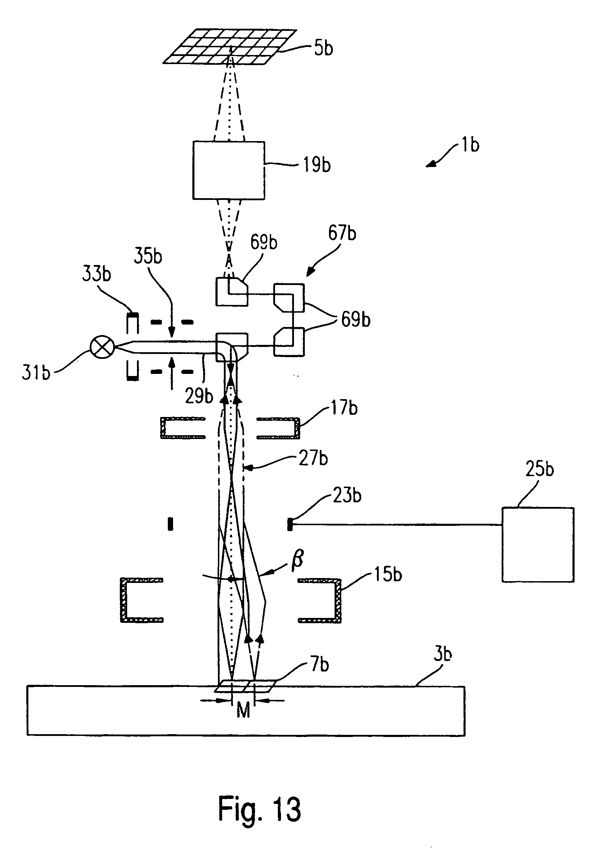

Ein in Figur 13 schematisch dargestelltes Untersuchungssystem 1b ist im wesentlichen ähnlich aufgebaut, wie das in Figur 12 dargestellte Untersuchungssystem. Es dient ebenfalls zur Abbildung von Rückstreuelektronen, die aus einem in der Ebene des Objekts 3b verlagerbaren Feld 7b austreten, auf einen Detektor 5b. Im Unterschied zu der in Figur 12 gezeigten Ausführungsform sind hier allerdings nicht zwei separate Deflektoren vorgesehen, um die änderbare Auslenkung M des abzubildenden Feldes 7b zu erzeugen. Es ist lediglich ein Deflektor 23b vorgesehen, und die Funktion des zweiten Deflektors wird durch eine dem Objekt 3b nahe Fokussierlinse 15b übernommen. Ein hierfür geeigneter Aufbau der Fokussierlinse 15b ist in DE 196 34 456 A1 offenbart und umfaßt ein elektrisches oder magnetisches Zylinderlinsenfeld, dem ein stationäres elektrisches oder magnetisches Quadrupolfeld überlagert ist.

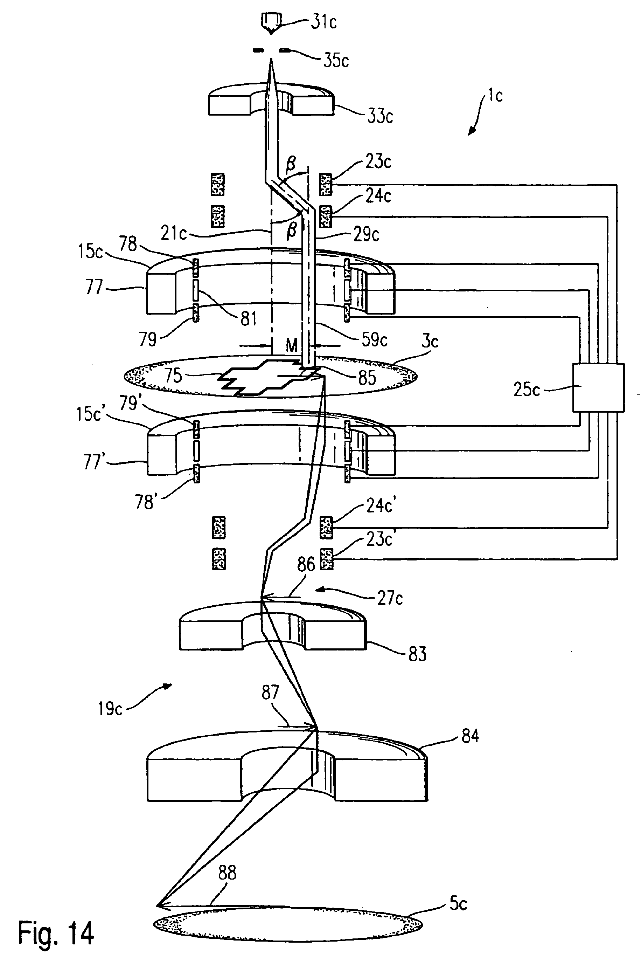

Ein in Figur 14 schematisch dargestelltes Untersuchungssystem 1c dient zur Beobachtung von Transmissionselektronen, die aus einem Feld in der Ebene eines Objekts 3c austreten, auf einen Detektor 5c. Das Objekt 3c ist eine Lithographiemaske zur Abbildung einer Struktur 75 auf einen Wafer in einem Lithographieprozeß. Das mittels der Transmissionselektronen auf den Detektor 5c abgebildete Feld ist in der Ebene des Objekts verlagerbar (Auslenkung M).

Zur Formung eines Strahls Primärelektronen 29c zur Beleuchtung des auf den Detektor 5c abzubildenden Feldes in der Objektebene ist eine Elektronenkanone 31c, eine Blende 35c und eine Fokussierlinse 33c vorgesehen. Nach der Fokussierlinse 33c durchläuft der Primärelektronenstrahl nacheinander zwei mit Abstand voneinander angeordnete Deflektoren 23c und 24c, die den Strahl um jeweils entgegengesetzt gleiche Winkel β ablenken, um die Auslenkung M zu erzeugen. Der Primärelektronenstrahl 29c wird sodann durch eine Fokussierlinse 15c auf das Objekt 3c fokussiert, um dort das abzubildende Feld zu beleuchten. Die Fokussierlinse 15c ist eine Linse mit variabler optischer Achse, wie sie auf E. Goto zurückgeht. Hierzu umfaßt sie eine Rundlinse 77 zur Bereitstellung eines bezüglich einer Hauptachse 21c rotationssymmetrischen fokussierenden Magnetfelds und Spulen 78, 79 zur Erzeugung eines magnetischen Dipolfeldes. Der Strom durch die Dipolspulen 78, 79 ist durch eine Steuerung 25c derart einstellbar, daß die Überlagerung des stationären Rundlinsenfeldes und der Dipolfelder zu einer Wirkung eines Rundlinsenfeldes führt, dessen Symmetrieachse 59c ebenfalls um den Betrag M von der Hauptachse 21c weg verlagert ist. Mit 81 ist in Figur 14 eine dynamische Fokusspule dargestellt, die ebenfalls von der Steuerung 25c angesteuert wird, um die Wirkung der Fokussierlinse 15c bei verschiedenen Auslenkungen M zu optimieren.

Um die das Objekt 3c durchsetzenden Transmissionselektronen bei ausgelenktem Feld auf die Hauptachse 21c bzw. einem in Figur 14 mit 27c bezeichneten festen Strahlquerschnitt, der unabhängig von der Auslenkung M ist, zurückzuführen, ist für die Transmissionselektronen eine Strahlführung mit Komponenten vorgesehen, die symmetrisch zu den Komponenten der Strahlführung zur Auslenkung der Primärelektronen aufgebaut sind. Die Komponenten für die Strahlführung der Transmissionselektronen sind mit den gleichen Bezugszeichen wie die entsprechenden Komponenten zur Strahlführung der Primärelektronen bezeichnet, zusätzlich jedoch mit einem ' versehen. Diese Strahlführung umfaßt damit eine dem Objekt nahe Fokussierlinse 15c' mit variabler Achse und zwei Deflektoren 24c' und 23c'.

Im Strahlengang nachfolgend zu dem auslenkungsunabhängigen festen Strahlquerschnitt 27c ist eine Nachvergrößerungsoptik 19c mit zwei Rundlinsen 83, 84 vorgesehen, bevor die Transmissionselektronen auf den Detektor 5c treffen.

Aus dem in Figur 14 dargestellten Strahlengang für die Transmissionselektronen ist ersichtlich, wie eine Objektgröße 85 über Zwischenbilder 86, 87 in ein Bild 88 auf dem Detektor 5c abgebildet wird.

Alternativ zu den dem Objekt 3a nahen Fokussierlinsen 15c bzw. 15c' mit variabler optischer Achse können eine oder beide dieser Linsen durch eine Linse ersetzt werden, wie sie im Zusammenhang mit den Figuren 5 bis 13 vorangehend erläutert wurde.

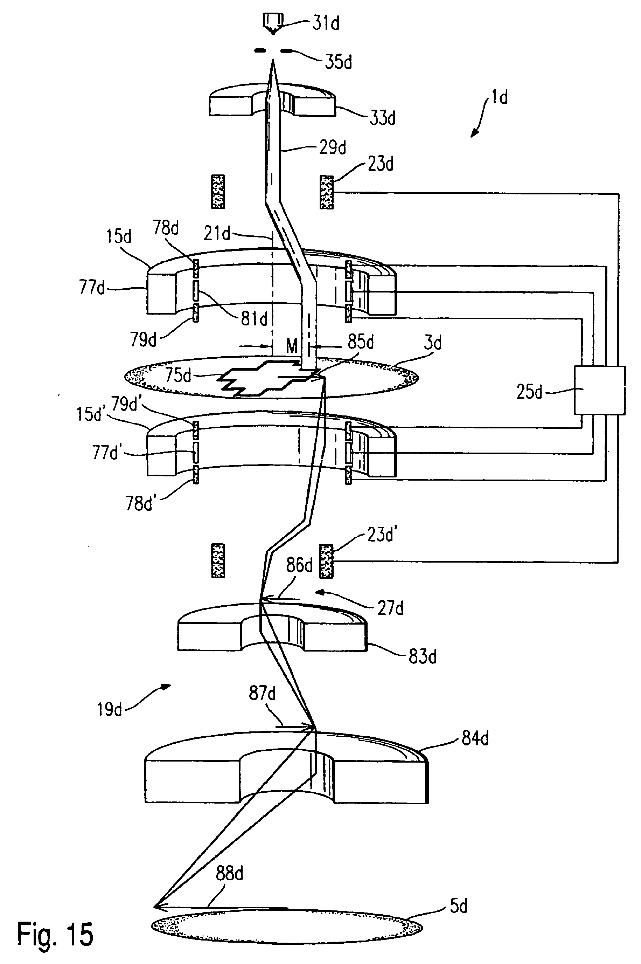

Ein in Figur 15 schematisch dargestelltes Untersuchungssystem 1d ist ähnlich aufgebaut, wie das in Figur 14 gezeigte Untersuchungssystem. Es dient zur Abbildung eines bezüglich einer Hauptachse 21d auslenkbaren Feldes in der Ebene eines Objekts 3d auf einen Detektor 5d. Im Unterschied zu den in der Ausführungsform gemäß Figur 14 vorgesehenen zwei separaten Deflektoren zur Erzeugung der Auslenkung eines Primärstrahles 29d aus der Hauptachse 21d ist hier jedoch lediglich ein separater Deflektor 23d vorgesehen, und die Funktion des zweiten Deflektors ist durch eine dem Objekt 3d nahe Fokussierlinse 15d bereitgestellt. Der für die Zurückführung der Transmissionselektronen auf die Hauptachse 21d bzw. hin zu einem von der Auslenkung M unabhängigen Strahlquerschnitt 27d bereitgestellte Strahlengang ist hinsichtlich seiner Komponenten symmetrisch aufgebaut zu der Strahlführung für die Primärelektronen, und die hierfür vorgesehenen Komponenten, nämlich die Fokussierlinse 15d' und der Deflektor 23d' sind mit entsprechenden Bezugszeichen jedoch mit einem zusätzlichen versehen.

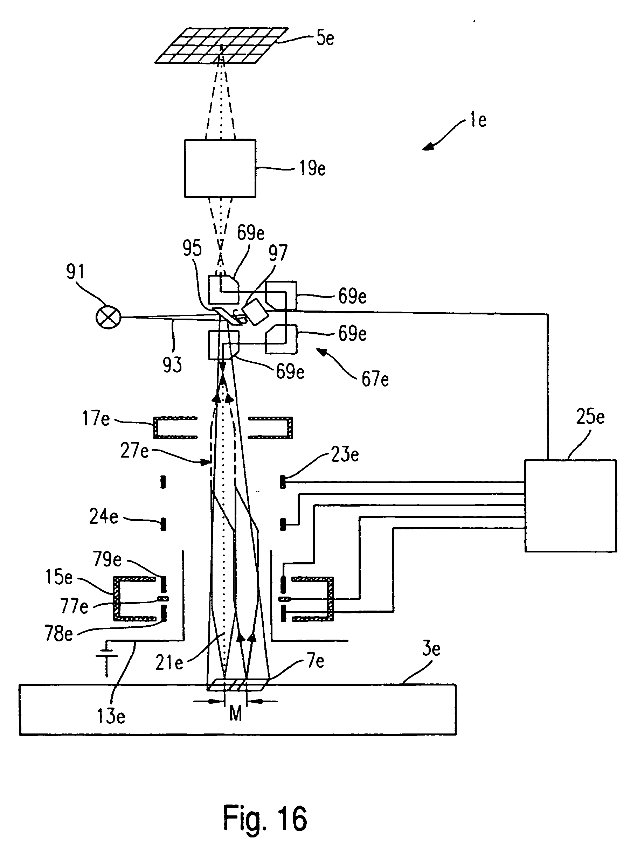

Ein in Figur 16 schematisch dargestelltes Untersuchungssystem 1e dient zur Abbildung von Photoelektronen, die aus einem räumlich begrenzten Feld 7e auf der Oberfläche eines zu untersuchenden Objekts 3e austreten, auf einen Detektor 5e. Das abzubildende Feld 7e ist bezüglich einer Hauptachse 21e bzw. einem festen Strahlquerschnitt 27e auslenkbar (Auslenkung M). Das elektronenoptische System zur Führung der aus dem Objekt 3e austretenden Photoelektronen hin zu dem Detektor 5e ist ähnlich aufgebaut, wie das im Zusammenhang mit der in Figur 7 gezeigten Ausführungsform erläuterten System zur Führung der Rückstreuelektronen zum Detektor, wobei allerdings eine Elektrode 13e vorgesehen ist, um die Photoelektronen nach ihrem Austritt aus dem Objekt 3e zu beschleunigen.

Die Auslenkung M wird durch zwei mit Abstand in Richtung der Hauptachse 21e angeordnete Deflektoren 23e und 24e erzeugt, und eine dem Objekt nahe Fokussierlinse 15e ist als Linse mit variabler Achse aufgebaut und umfaßt Dipolspulen 78e und 79e sowie zusätzlich in Abhängigkeit von der Auslenkung M angesteuerte dynamische Fokusspulen 77e.

Ferner ist ein abbildungserhaltendes Energiefilter 67e vorgesehen, um das Energiespektrum der Photoelektronen, welches einer Nachvergrößerungsoptik 19e zugeführt ist, zu beschneiden. Das Energiefilter 67e umfaßt mehrere Sektormagnete, wobei die Photoelektronen durch den Sektormagnet 69e des Energiefilters 67e, in den sie zuerst eintreten, von der Hauptachse 21e weggeführt werden.

Die Beleuchtung des abzubildenden Feldes 7e mit Photonen zur Erzeugung der Photoelektronen erfolgt mittels einer Lichtquelle 91, die einen Lichtstrahl 93 erzeugt, der auf einen auf der Hauptachse 21e angeordneten Umlenkspiegel 95 gerichtet ist. Der Umlenkspiegel 95 ist dabei an einer Stelle der Hauptachse 21e angeordnet, an der der Strahl Photoelektronen bereits durch den ersten Sektormagnet 69e von der Hauptachse 21e weg gelenkt wurde.

Der Umlenkspiegel 95 ist mittels eines durch die Steuerung 25e kontrollierten Antriebs 97 verschwenkbar. Die Steuerung 25e kontrolliert die Verschwenkung des Umlenkspiegels 95 in Abhängigkeit von der Auslenkung M des auf den Detektor 5e abgebildeten Feldes 7e derart, daß immer das abgebildete Feld 7e mit Photonen der Lichtquelle 91 beleuchtet wird. Hierbei entspricht der mit Photonen beleuchtete Bereich in der Ebene des Objekts 3e hinsichtlich seiner Geometrie im wesentlichen dem Feld 7e, das elektronenoptisch auf den Detektor 5e abgebildet wird.

Alternativ zu der Ausbildung der dem Objekt 3e nahen Fokussierlinse 15e als Linse mit variabler Achse ist es auch möglich, als Fokussierlinse 15e eine solche Linse einzusetzen, wie sie im Zusammenhang mit den Figuren 5 bis 11 erläutert wurde.

Ferner ist es ebenfalls möglich, zur Bereitstellung der Auslenkung M nicht zwei nacheinander angeordnete separate Deflektoren 23e und 24e einzusetzen, sondern lediglich einen separaten Deflektor vorzusehen und die Funktion des zweiten Deflektors durch die Fokussierlinse 15e bereitzustellen, wie dies bei der im Zusammenhang mit Figur 8 erläuterten Ausführungsform dargestellt wurde.

Bei den vorangehend erläuterten Ausführungsformen, bei denen Sekundärelektronen und Rückstreuelektronen auf den Detektor abgebildet werden, wird die Deflektoreinrichtung sowohl von den Primärelektronen als auch den Sekundär- bzw. Rückstreuelektronen durchlaufen. Dies stellt an die Deflektoreinrichtung besondere Anforderungen, da sowohl die Primärelektronen als auch die Sekundär- bzw. Rückstreuelektronen im wesentlichen gleiche Auslenkungen erfahren sollen. Bei den Ausführungsformen, bei denen Transmissionselektronen und Photoelektronen auf den Detektor abgebildet werden, sind hingegen die Anforderungen an die Deflektoreinrichtung geringer, da lediglich die von dem Objekt zu dem Detektor hin verlaufenden Elektronen definiert abzulenken sind. Es können dann auch Deflektoren eingesetzt werden, die lediglich ein änderbares elektrisches Feld oder ein änderbares magnetisches Feld bereitstellen.

In den vorangehend dargestellten Ausführungsformen, die mit Photoelektronen arbeiten, wurde ein Schwenkspiegel eingesetzt, um das mit Photonen beleuchtete Feld in der Objektebene zu verlagern. Alternativ hierzu können auch andere Maßnahmen eingesetzt werden, um die Photonen änderbar abzulenken. Ein Beispiel hierfür ist ein akustooptischer Modulator.

Im Zusammenhang mit den Figuren 5 bis 11 wurden Ausführungsformen der ersten Fokussierlinse beschrieben, welche als teilchenoptische. Fokussiereinrichtung mit einer Kammblende arbeiten. Unabhängig von dem Einsatz dieser Fokussiereinrichtung in dem vorangehend geschilderten Untersuchungssystem ist auch daran gedacht, hieran Abwandlungen vorzunehmen. So ist beispielsweise vorgesehen, auch die dem Objekt am nächsten angeordnete Blende, welche vorangehend als einfache Schlitzblende beschrieben wurde, als Kammblende auszubilden, so daß über diese Kammblende noch zusätzlich Eingriff auf den Potentialverlauf der Fokussiereinrichtung genommen werden kann und dieser Eingriff auch noch entlang der Schlitzrichtung verlagerbar gestaltet werden kann. Ebenso ist es auch möglich, eine oder gar beide der der Kammblende 58 benachbarten Blenden 51 und 53 in Figur 2 selbst ebenfalls als Kammblende auszubilden.

**Patentansprüche**

1. Untersuchungssystem zum Abbilden eines in einer Objektebene anordenbaren Objektes (3), umfassend:

   - eine Beleuchtungseinrichtung (31; 91), um einem begrenzten Feld des Objekts (3) Energie derart zuzuführen, daß geladene Teilchen von Orten des Feldes austreten, wobei das Feld in der Ebene des Objektes (3) verlagerbar ist,
   - eine erste Deflektoreinrichtung (23, 24) zur Bereitstellung eines änderbaren Ablenkfeldes, um an Orten eines auswählbaren Bereiches (7) des Objektes (3) austretende geladene Teilchen durch einen festen vorbestimmten Strahlquerschnitt (27) zu führen,
   - einen derart im Strahlengang angeordneten ortsauflösenden Detektor (5), daß die geladenen Teilchen nach Durchlaufen der ersten Deflektoreinrichtung (23, 24) auf diesen treffen, wobei von verschiedenen Orten des Bereiches (7) austretende Teilchen auf den Austrittsorten zugeordnete verschiedene Orte des ortsauflösenden Detektors (5) abgebildet werden, und
   - eine Steuerung (25), um die Beleuchtungseinrichtung (31; 91) im Hinblick auf eine Änderung der Verlagerung des beleuchteten Feldes anzusteuern, und um die erste Deflektoreinrichtung (23, 34) derart anzusteuern, daß der auf den Detektor abgebildete Bereich (7) des Objekts gemeinsam mit dem beleuchteten Feld in der Objektebene verlagert wird.

2. Untersuchungssystem nach Anspruch 1, wobei das beleuchtete Feld im wesentlichen mit dem auf den Detektor abgebildeten Bereich (7) zusammenfällt.

3. Untersuchungssystem nach Anspruch 1 oder 2, ferner umfassend eine zwischen dem Objekt (3) und dem festen Strahlquerschnitt (27) angeordnete erste Fokussierlinseneinrichtung (15) zur Bereitstellung eines Ablenkfeldes, das auf die von den Orten des auf den Detektor (5) abgebildeten Bereichs austretenden Teilchen die Wirkung einer fokussierenden Linse hat.

4. Untersuchungssystem nach Anspruch 3, wobei das Ablenkfeld änderbar ist und die Steuerung ferner dazu vorgesehen ist, die erste Fokussierlinseneinrichtung (15) derart anzusteuern, daß eine optische Achse (59) der fokussierenden Linse quer zu deren Achsrichtung verlagerbar ist.

5. Untersuchungssystem nach Anspruch 4, wobei die Steuerung (25) ferner dazu vorgesehen ist, die erste Fokussierlinseneinrichtung (15) derart anzusteuern, daß deren optische Achse (59) den abgebildeten Bereich (7) unabhängig von der Verlagerung des abgebildeten Bereichs (7) insbesondere im wesentlichen zentral schneidet.

6. Untersuchungssystem nach einem der Ansprüche 1 bis 5, wobei die erste Fokussierlinseneinrichtung (15) eine teilchenoptische Fokussiereinrichtung zur Bereitstellung von auf einen Strahl geladener Teilchen fokussierend wirkenden Ablenkfeldern ist, welche umfaßt:

   wenigstens drei in einer Richtung (z) des Strahls mit Abstand und elektrisch isoliert voneinander angeordnete Blenden, die jeweils einen Bereich mit einer zusammenhängenden Öffnung für einen freien Strahldurchtritt aufweisen, wobei die Öffnungen jeweils in einer ersten Richtung (x) quer zur Strahlrichtung sich über eine Länge erstrecken, die größer ist als eine Breite, in die sich die Öffnungen in einer quer zur ersten Richtung und quer zur Strahlrichtung ausgerichteten zweiten Richtung (y) erstrecken, und wobei wenigstens eine zwischen zwei in Strahlrichtung benachbarten Blenden angeordnete Blende als Kammblende ausgebildet ist, die, gesehen in der ersten Richtung (x), beidseits der Öffnung jeweils eine Vielzahl von mit Abstand und elektrisch isoliert voneinander angeordnete Elektroden aufweist.

**7.** Untersuchungssystem nach Anspruch 6, wobei eine von der Kammblende verschiedene erste Blende wenigstens einen Elektrodenbereich aufweist, der im Bereich der Öffnung sich in Strahlrichtung über eine Strecke erstreckt, die größer ist als das 0,25fache, vorzugsweise größer als das 0,5-fache, stärker bevorzugt größer als das 0,75-fache, insbesondere das 0,9-fache oder das 1,3-fache der Breite der Öffnung im Bereich des Elektrodenbereichs.

**8.** Untersuchungssystem nach Anspruch 6, wobei eine zweite Blende und eine dritte Blende vorgesehen sind, die jeweils von der Kammblende verschieden sind und in Strahlrichtung mit Abstand voneinander und unmittelbar benachbart zueinander angeordnet sind, und die jeweils im Bereich der Öffnung wenigstens einen Elektrodenbereich aufweisen, wobei die Elektrodenbereiche in Strahlrichtung eine Strecke entfernt voneinander angeordnet sind, die größer ist als als das 0,5-fache, vorzugsweise das 0,75-fache, insbesondere das 0,9-fache oder das 1,3-fache der Breite der Öffnung im Bereich des Elektrodenbereichs.

**9.** Untersuchungssystem nach einem der Ansprüche 6 bis 8, wobei die teilchenoptische Fokussiereinrichtung ferner eine Ablenkfeld-Steuereinrichtung umfaßt, die dazu ausgebildet ist, an eine Mehrzahl der Elektroden der Kammblende elektrische Potentiale derart anzulegen, daß die Mehrzahl der Elektroden angenähert ein Quadrupolfeld erzeugt, dessen Symmetrieachse sich innerhalb der Öffnung im wesentlichen in Strahlrichtung erstreckt.

**10.** Untersuchungssystem nach Anspruch 9, wobei die Ablenkfeld-Steuereinrichtung dazu ausgebildet ist, die elektrischen Potentiale derart anzulegen, daß die Symmetrieachse an mehreren in der ersten Richtung zueinander versetzten auswählbaren Orten anordenbar ist.

**11.** Untersuchungssystem nach Anspruch 10, wobei die Symmetrieachse in der ersten Richtung (x) im wesentlichen kontinuierlich verschiebbar ist.

**12.** Untersuchungssystem nach einem der Ansprüche 9 bis 11, wobei die Ablenkfeld-Steuereinrichtung dazu ausgebildet ist, ein mittlere elektrische Potential von wenigstens zwei Blenden relativ zueinander einzustellen.

**13.** Untersuchungssystem nach einem der Ansprüche 6 bis 12, wobei die Elektroden der Kammblende in Strahlrichtung eine Ausdehnung aufweisen, die etwa einem 0,5-fachen bis 1,5-fachen der Breite der Öffnung im Bereich der Elektroden entspricht.

**14.** Untersuchungssystem nach einem der Ansprüche 6 bis 13, wobei ferner die erste oder/und die zweite oder/und die dritte Blende als Kammblende ausgebildet ist, deren Elektroden durch die Ablenkfeld-Steuereinrichtung auswählbare elektrische Potentiale zuführbar sind.

**15.** Untersuchungssystem nach einem der Ansprüche 1 bis 14, wobei die Beleuchtungseinrichtung eine Photonenquelle (91) aufweist, um das Feld zu beleuchten, wobei die von den Orten des abgebildeten Bereichs (7) austretenden geladenen Teilchen durch Photonen der Photonenquelle (91) erzeugte Photoelektronen umfassen.

**16.** Untersuchungssystem nach Anspruch 15, wobei eine Ablenkeinrichtung (95) mit einem bewegbaren Spiegel vorgesehen ist, um durch Bewegung des Spiegels das beleuchtete Feld zu verlagern.

**17.** Untersuchungssystem nach einem der Ansprüche 1 bis 16, wobei die Beleuchtungseinrichtung eine Elektronenquelle (31) aufweist, um das Feld zu beleuchten, und wobei die von den Orten des abgebildeten Bereichs (7) austretenden geladenen Teilchen durch Elektronen der Elektronenquelle (31) erzeugte Sekundärelektronen oder/und Rückstreuelektronen oder/und Transmissionselektronen umfassen.

**18.** Untersuchungssystem nach Anspruch 17, wobei die Beleuchtungseinrichtung wenigstens eine Blende (35) zur Formung eines das Feld beleuchtenden Beleuchtungsstrahls (29) oder/und zur Einstellung einer numerischen Apertur der Beleuchtung aufweist.

**19.** Untersuchungssystem nach Anspruch 17 oder 18, wobei die Beleuchtungseinrichtung (31c) und die erste Fokussierlinseneinrichtung (15c') auf gegenüberliegenden Seiten der Objektebene angeordnet sind und die Beleuchtungseinrichtung (31c) eine durch die Steuerung (25c) ansteuerbare zweite Deflektoreinrichtung (15c) aufweist, um den Strahl zur Verlagerung des Feldes auszulenken.

**20.** Untersuchungssystem nach Anspruch 17 oder 18, wobei die Beleuchtungseinrichtung (31; 31a; 31b) und die erste Fokussierlinseneinrichtung (15; 15a; 15b) auf einer gleichen Seite bezüglich der Objektebene angeordnet sind.

**21.** Untersuchungssystem nach Anspruch 20, wobei eine Strahlführungseinrichtung vorgesehen ist, um die von der Quelle (31; 31a; 31b) emittierten Elektronen durch den festen Strahlquerschnitt (27; 27a; 27b) in Richtung zu dem Objekt (3) hin zu führen, wobei die zu dem Objekt (3) hin verlaufenden Elektronen auch die erste Deflektoreinrichtung (23, 24) und die erste Fokussierlinseneinrichtung (15) durchlaufen.

**22.** Untersuchungssystem nach Anspruch 21, wobei, beim Durchlaufen der ersten Deflektoreinrichtung (15), die zu dem Objekt (3) hin verlaufenden Elektronen eine höhere kinetische Energie aufweisen als die von dem Objekt (3) zu dem Detektor (5) verlaufenden Elektronen, und wobei die erste Deflektoreinrichtung (23, 24) derart ausgebildet ist, daß das durch sie bereitgestellte Ablenkfeld für die zu dem Objekt (3) hin verlaufenden Elektronen und die von dem Objekt (3) zu dem Detektor (5) verlaufenden Elektronen im wesentlichen gleiche Ablenkungen (M) bereitstellt.

**23.** Untersuchungssystem nach Anspruch 22, wobei die erste Deflektoreinrichtung wenigstens einen Bereich (37) mit einem durch die Steuerung (25) änderbaren elektrischen Ablenkfeld und einem durch die Steuerung änderbaren magnetischen Ablenkfeld (40) aufweist, wobei Feldrichtungen des elektrischen und des magnetischen Ablenkfeldes sowie Bewegungsrichtungen der Elektronen in diesem Bereich (37) paarweise im wesentlichen orthogonal zueinander ausgerichtet sind.

**24.** Untersuchungssystem nach Anspruch 23, wobei die Steuerung (25) die erste Deflektoreinrichtung (23, 24) derart ansteuert, daß in dem wenigstens einen Bereich (37) in etwa die Beziehung

$$B = k \cdot E$$

erfüllt ist, wobei

B eine Feldstärke des magnetischen Feldes in dem Bereich (37),
E eine Feldstärke des elektrischen Feldes in dem Bereich (37) und
k eine Konstante

ist.

**25.** Untersuchungssystem nach einem der vorangehenden Ansprüche, wobei im Strahlengang zwischen dem festen Strahlquerschnitt (27) und dem Detektor (5) ein abbildendes Energiefilter (67) für die geladenen Teilchen vorgesehen ist.

**26.** Untersuchungssystem nach einem der vorstehenden Ansprüche, wobei die erste Deflektoreinrichtung eine Ablenkvorrichtung (23, 24) zum Ablenken eines die Ablenkvorrichtung (23, 24) in einer ersten Richtung durchlaufenden ersten Strahls (29) geladener Teilchen umfasst, mit einem Volumen (37) zur Bereitstellung eines Ablenkfeldes für den ersten Strahl, wobei die Ablenkvorrichtung (23, 24) umfasst:

eine Stromleiterwindungsanordnung mit einer Mehrzahl von in Umfangsrichtung um eine Achse (z) verteilt angeordneten Stromleiterwindungen (47) zur Erzeugung eines magnetischen Ablenkfeldes (40) in dem Volumen (37),
eine Elektrodenanordnung mit einer Mehrzahl von in Umfangsrichtung um die Achse (z) verteilt angeordneten Elektroden (38) zur Erzeugung eines elektrischen Ablenkfeldes in dem Volumen (37),

wobei die Steuerung (25) zur Einstellung von den Stromleiterwindungen (47) jeweils zuzuführenden Strömen und zur Einstellung von den Elektroden (38) jeweils zuzuführenden Spannungen ausgebildet ist, wobei die Ablenkvorrichtung (23, 24) ferner zum Ablenken eines die Ablenkvorrichtung in einer der ersten Richtung entgegengesetzten zweiten Richtung durchlaufenden zweiten Strahls (9, 10) geladener Teilchen ausgebildet ist, und wobei die Steuerung die Ströme und die Spannungen derart einstellt, daß der erste Strahl (29) um einen Winkel (β) abgelenkt wird, der im wesentlichen entgegengesetzt gleich einem Winkel (-β) ist, um den der zweite Strahl (9, 10) abgelenkt wird.

**27.** Untersuchungssystem nach Anspruch 26, wobei die Stromleiterwindungsanordnung einen oder eine Mehrzahl von mit axialem Abstand voneinander angeordneten Ringen (43) aus einem Material mit hoher magnetischer Permeabilität aufweist und wobei die Stromleiterwindungen (47) jeweils wenigstens einen der Ringe (43) umgreifen.

**28.** Untersuchungssystem nach einem der Ansprüche 1 bis 25, wobei die erste Deflektoreinrichtung eine Ablenkvorrichtung (23, 24) zum Ablenken eines die Ablenkvorrichtung (23, 24) in einer ersten Richtung durchlaufenden ersten Strahls (29) geladener Teilchen umfasst, mit einem Volumen (37) zur Bereitstellung eines Ablenkfeldes für den ersten Strahl, wobei die Ablenkvorrichtung (23, 24) umfasst:

eine Stromleiterwindungsanordnung mit einer Mehrzahl von in Umfangsrichtung um eine Achse (z) verteilt angeordneten Stromleiterwindungen (47) zur Erzeugung eines magnetischen Ablenkfeldes (40) in dem Volumen (37),
eine Elektrodenanordnung mit einer Mehrzahl von in Umfangsrichtung um die Achse (z) verteilt angeordneten Elektroden (38) zur Erzeugung eines elektrischen Ablenkfeldes in dem Volumen (37),

wobei die Steuerung (25) zur Einstellung von den Stromleiterwindungen (47) jeweils zuzuführenden Strömen und zur Einstellung von den Elektroden (38) jeweils zuzuführenden Spannungen ausgebildet ist,

wobei die Stromleiterwindungsanordnung einen oder eine Mehrzahl von mit axialem Abstand voneinander angeordneten Ringen (43) aus einem Material mit hoher magnetischer Permeabilität aufweist und wobei die Stromleiterwindungen (47) jeweils wenigstens einen der Ringe (43) umgreifen.

29. Untersuchungssystem nach Anspruch 27 oder 28, wobei die Ablenkvorrichtung ferner ein Vakuumrohr umfasst, wobei die Ringe radial außerhalb und die Elektroden radial innerhalb des Vakuumrohrs angeordnet sind.

**Claims**

1. An examining system for imaging an object (3) which is positionable in an object plane, comprising

    - an illumination device (31; 91) for supplying energy to a delimited field of the object (3) such that charged particles emerge from locations of the field, the field being displaceable in the plane of the object (3),
    - a first deflector (23, 24) for providing a variable deflection field for guiding charged particles emerging from locations of a selectable region (7) of the object (3) through a fixed, predetermined beam cross-section (27),
    - a position-sensitive detector (5) disposed in the beam path such that the charged particles, after having passed through the first deflector (23, 24), impinge on the detector, wherein particles emerging from different locations of the region (7) are imaged on different locations of the position-sensitive detector (5) which are allocated to the locations of emergence, and
    - a controller (25) for controlling the illumination device (31; 91) to change the displacement of the illuminated field and for controlling the first deflector (23, 24) such that the region (7) of the object imaged on the detector is displaced together with the illuminated field in the object plane.

2. The examining system according to claim 1, wherein the illuminated field substantially coincides with the region (7) imaged on the detector.

3. The examining system according to claim 1 or 2, further comprising a first focusing lens device (15) disposed between the object (3) and the fixed beam cross-section (27) for providing a deflection field which acts on the particles emerging from the locations of the region imaged on the detector (5) like a focusing lens.

4. The examining system according to claim 3, wherein the deflection field is variable and the controller is furthermore provided for controlling the first focusing lens device (15) such that an optical axis (59) of the focusing lens is displaceable transversely to the axial direction thereof.

5. The examining system according to claim 4, wherein the controller (25) is furthermore provided for controlling the first focusing lens device (15) such that the optical axis (59) thereof intersects the imaged region (7) substantially centrally irrespective of the displacement of the imaged region (7).

6. The examining system according to one of claims 1 to 5, wherein the first focusing lens device (15) is a particle-optical focusing device for providing deflection fields having a focusing effect on a beam of charged particles, comprising:

    at least three apertures which are electrically insulated and spaced apart from one another in a direction (z) of the beam, each of said apertures comprising a region with a continuous opening for a free beam traversal,
    each of said openings extending in a first direction (x) transverse to the beam direction over a length which is larger than a width into which the openings extend in a second direction (y) oriented transversely to the first direction and transversely to the beam direction,
    and wherein at least one aperture disposed between two apertures positioned adjacent to each other in the beam direction is provided as a comb aperture which comprises on each side of the opening, as seen in the first direction (x), a plurality of electrodes which are electrically insulated and disposed spaced apart from one another.

7. The examining system according to claim 6, wherein a first aperture which is different from the comb aperture comprises at least one electrode region extending in the region of the opening in beam direction over a distance which is larger than 0.25 times, preferably larger than 0.5 times, particularly preferred larger than 0.75 times and especially larger than 0.9 times or 1.3 times the width of the opening in the region of the electrode region.

8. The examining system according to claim 6, wherein a second aperture and a third aperture are provided which are each different from the comb aperture and are disposed spaced apart from one another in beam direction and directly adjacent to one another, each of said second and third apertures comprising at least one electrode region in the region of the opening, said electrode regions being disposed spaced apart from one another in beam direction by a distance which is larger than 0.5 times, preferably larger than 0.75 times, especially larger than 0.9 or 1.3 times the width of the opening in the region of the electrode region.

9. The examining system according to one of claims 6 to 8, wherein the particle-optical focusing device further comprises a deflection field controller for applying electric potentials to a plurality of electrodes of the comb aperture such that the plurality of electrodes produces approximately a quadrupole field, the axis of symmetry of which extends substantially in beam direction within the opening.

10. The examining system according to claim 9, wherein the deflection field controller is provided to apply the electric potentials such that the axis of symmetry can be positioned at several selectable locations which are offset from each other in the first direction.

11. The examining system according to claim 10, wherein the axis of symmetry is substantially continuously displaceable in the first direction (x).

12. The examining system according to one of claims 9 to 11, wherein the deflection field controller is provided to adjust a mean electric potential of at least two apertures relative to each other.

13. The examining system according to one of claims 6 to 12, wherein the electrodes of the comb aperture have a dimension in beam direction which is about 0.5 times to 1.5 times the width of the opening in the region of the electrodes.

14. The examining system according to one of claims 6 to 13, wherein, furthermore, the first or/and the second or/and the third aperture is provided as comb aperture, the electrodes thereof being adapted to be supplied with selectable electric potentials by means of the deflection field controller.

15. The examining system according to one of claims 1 to 14, wherein the illumination device comprises a photon source (91) to illuminate the field, wherein the charged particles emerging from the locations of the imaged region (7) comprise photoelectrons generated from photons of the photon source (91).

16. The examining system according to claim 15, further comprising a deflector (95) having a movable mirror to displace the illuminated field by movement of the mirror.

17. The examining system according to one of claims 1 to 16, wherein the illumination device comprises an electron source (31) to illuminate the field, and wherein the charged particles emerging from the locations of the imaged region (7) comprise secondary electrons or/and backscattering electrons or/and transmission electrons generated from electrons of the electron source (31).

18. The examining system according to claim 17, wherein the illumination device comprises at least one aperture (35) for shaping an illumination beam (29) illuminating the filed or/and for adjusting a numerical aperture of the illumination.

19. The examining system according to claim 17 or 18, wherein the illumination device (31c) and the first focusing lens device (15c') are disposed on opposite sides of the object plane and the illumination device (31c) comprises a second deflector (15c) to deflect the beam for displacing the field, said second deflector being controllable by the controller (25c).

20. The examining system according to claim 17 or 18, wherein the illumination device (31; 31a; 31b) and the first focusing lens device (15; 15a; 15b) are disposed on a same side relative to the object plane.

21. The examining system according to claim 20, wherein a beam guiding device is provided to guide the electrons emitted from the source (31; 31a; 31b) through the fixed beam cross-section (27; 27a; 27b) towards the object (3), the electrons travelling towards the object (3) also passing through the first deflector (23, 24) and the first focusing lens device (15).

22. The examining system according to claim 21, wherein, when passing through the first deflector (15), the electrons travelling towards the object (3) have a higher kinetic energy than the electrons travelling from the object (3) to the detector (5), and wherein the first deflector (23, 24) is provided such that the deflection field generated by the same provides substantially equal deflections (M) for the electrons travelling towards the object (3) and the electrons travelling from the object (3) to the detector (5).

23. The examining system according to claim 22, wherein the first deflector comprises at least one region (37) with an electric deflection field which is variable by the controller (25) and a magnetic deflection field (40) which is variable by the controller, with field directions of the electric deflection field and the magnetic deflection field as well as directions of movement of the electrons in this region (37) being oriented in pairs substantially orthogonally to each other.

24. The examining system according to claim 23, wherein the controller (25) controls the first deflector (23, 24) such that in the at least one region (37) the relation

$$B = k \cdot E$$

is approximately fulfilled, wherein

    B is a field strength of the magnetic field in the region (37),
E is a field strength of the electric field in the region (37), and
k is a constant.

25. The examining system according to one of the preceding claims, wherein an imaging energy filter (67) for the charged particles is provided in the beam path between the fixed beam cross-section (27) and the detector (5).

26. The examining system according to one of the preceding claims, wherein the first deflector comprises a deflector (23, 24) which serves to deflect a first beam (29) of charged particles passing through the deflector (23, 24) in a first direction and has a volume (37) for providing a deflection field for the first beam, said deflector (23, 24) comprising:

    a current conductor winding arrangement comprising a plurality of current conductor windings (47) circumferentially distributed about an axis (z) for producing a magnetic deflection field (40) in the volume (37),
an electrode arrangement comprising a plurality of electrodes (38) circumferentially distributed about the axis (z) for producing an electric deflection field in the volume (37),

wherein the controller (25) is adapted to adjust currents to be supplied to the conductor windings (47) and to adjust voltages to be applied to the electrodes (38),
wherein the deflector (23, 24) is further adapted to deflect a second beam (9, 10) of charged particles travelling in a second direction oriented opposed to the first direction, and wherein
the controller adjusts the currents and voltages such that the first beam (29) is deflected through an angle (β) which is substantially oppositely equal to an angle (-β) through which the second beam (9, 10) is deflected.

27. The examining system according to claim 26, wherein the current conductor winding arrangement comprises one or more rings (43) which are spaced axially apart from one another and are made of a material of high magnetic permeability, and wherein each of the current conductor windings (47) engages at least around one of the rings (43).

28. The examining system according to one of claims 1 to 25, wherein the first deflector comprises a deflector (23, 24) which serves to deflect a first beam (29) of charged particles passing through the deflector (23, 24) in a first direction and has a volume (37) for providing a deflection field for the first beam, said deflector (23, 24) comprising:

    a current conductor winding arrangement comprising a plurality of current conductor windings (47) circumferentially distributed about an axis (z) for producing a magnetic deflection field (40) in the volume (37),
an electrode arrangement comprising a plurality of electrodes (38) circumferentially distributed about the axis (z) for producing an electric deflection field in the volume (37),
wherein the controller (25) is adapted to adjust currents to be supplied to the conductor windings (47) and to adjust voltages to be applied to the electrodes (38),
wherein the current conductor winding arrangement comprises one or more rings (43) which are spaced axially apart from one another and are made of a material of high magnetic permeability, and wherein each of the current conductor windings (47) engages at least around one of the rings (43).

29. The examining system according to claim 27 or 28, wherein the deflector further comprises a vacuum tube, the rings being disposed radially outwardly and the electrodes being disposed radially inwardly of the vacuum tube.

**Revendications**

1. Système d'inspection pour l'imagerie d'un objet (3) pouvant être agencé dans un plan objet, comprenant :

    - un dispositif d'illumination (31 ; 91), pour alimenter en énergie un champ délimité de l'objet (3) de telle manière que des particules chargées sortent de certains points du champ, sachant que le champ peut être déplacé dans le plan de l'objet (3),
- un premier déflecteur (23, 24) pour la production d'un champ de déflexion modifiable, afin de guider sur des points d'une zone sélectionnable (7) de l'objet (3) des particules chargées sortant à travers l'ouverture fixe du faisceau (27) prédéterminée.
- un détecteur (5) de localisation agencé dans la trajectoire du faisceau de façon que, après avoir traversé le premier déflecteur (23, 24), les particules chargées se rencontrent sur celui-ci, dans lequel des particules sortant de différents points de la zone (7) sont représentées sur les différents points du détecteur de localisation (5) associés aux points de sortie, et

- une commande (25), pour commander le dispositif d'illumination (31 ; 91) compte tenu d'une modification du déplacement du champ éclairé, et pour commander le premier déflecteur (23, 34) de telle manière que la zone (7) de l'objet représentée sur le détecteur est déplacée en même temps que le champ éclairé dans le plan objet.

2. Système d'inspection selon la revendication 1, dans lequel le champ éclairé coïncide essentiellement avec la zone (7) représentée sur le détecteur.

3. Système d'inspection selon les revendications 1 ou 2, comprenant en outre un premier dispositif avec lentille de focalisation (15) agencé entre l'objet (3) et l'ouverture fixe du faisceau (27) pour la mise à disposition d'un champ de déflexion, qui a la fonction d'une lentille de focalisation sur les particules sortant des points de la zone représentée sur le détecteur (5).

4. Système d'inspection selon la revendication 3, dans lequel le champ de déflexion est modifiable et la commande est prévue en outre pour commander le premier dispositif avec lentille de focalisation (15) de telle manière qu'un axe optique (59) de la lentille de focalisation peut être déplacé transversalement à la direction de l'axe de celle-ci.

5. Système d'inspection selon la revendication 4, dans lequel la commande (25) est prévue en outre pour commander le premier dispositif avec lentille de focalisation (15) de telle manière que l'axe optique de celle-ci (59) coupe en particulier sensiblement au centre la zone représentée (17) indépendamment du déplacement de la zone représentée (17).

6. Système d'inspection selon l'une des revendications 1 à 5, dans laquelle le premier dispositif à lentille de focalisation (15) est un dispositif de focalisation optique corpusculaire pour la mise à disposition de champs de déflexion agissant par focalisation sur un faisceau de particules chargées, comprenant:

au moins trois filtres agencés dans une direction (z) du faisceau à distance les uns des autres et isolés électriquement, qui comportent respectivement une zone avec une ouverture continue pour un passage libre du faisceau,

dans lequel les ouvertures s'étendent respectivement dans une première direction (x) transversalement à la direction du faisceau sur une longueur qui est supérieure à une largeur dans laquelle les ouvertures s'étendent dans une direction transversale par rapport à la première direction et transversale par rapport à une deuxième direction (y) alignée sur la direction du faisceau,
et dans lequel au moins un filtre agencé entre deux filtres adjacents dans la direction du faisceau est configuré comme un filtre en peigne qui, vu dans la première direction (x) comporte des deux côtés de l'ouverture respectivement un grand nombre d'électrodes agencées à distance les unes des autres et isolées électriquement.

7. Système d'inspection selon la revendication 6, dans lequel un premier filtre différent du filtre en peigne comporte au moins une zone d'électrodes qui s'étend, au niveau de l'ouverture dans la direction du faisceau, sur une distance qui est supérieure à 0,25 fois, de préférence supérieure à 0,5 fois, encore mieux supérieure à 0,75 fois, en particulier à 0,9 fois ou à 1,3 fois, la largeur de l'ouverture au niveau de la zone des électrodes.

8. Système d'inspection selon la revendication 6, dans lequel un deuxième filtre et un troisième filtre sont prévus qui sont respectivement différents du filtre en peigne et sont agencés à distance l'un de l'autre dans la direction du faisceau et directement à proximité l'un à l'autre et qui comportent respectivement au niveau de l'ouverture au moins une zone d'électrodes, les zones d'électrodes étant agencées loin les unes des autres en direction du faisceau, d'une distance supérieure à 0,5 fois, de préférence à 0,75 fois, en particulier à 0,9 fois ou à 1,3 fois la largeur de l'ouverture au niveau de la zone des électrodes.

9. Système d'inspection selon l'une des revendications 6 à 8, dans lequel le dispositif de focalisation d'optique corpusculaire comprend en outre un dispositif de commande de champ de déflexion, qui est configuré pour appliquer des tensions électriques à une pluralité d'électrodes du filtre en peigne de telle manière que la pluralité d'électrodes produise approximativement un champ quadripolaire, dont l'axe de symétrie s'étend à l'intérieur de l'ouverture essentiellement dans la direction du faisceau.

10. Système d'inspection selon la revendication 9, dans lequel le dispositif de commande du champ de déflexion est configuré pour appliquer les tensions électriques de telle manière que l'axe de symétrie peut être agencé sur plusieurs points sélectionnables décalés les uns par rapport aux autres dans la première direction.

11. Système d'inspection selon la revendication 10, dans lequel l'axe de symétrie peut être déplacé essentiellement en continu dans la première direction (x).

**12.** Système d'inspection selon l'une des revendications 9 à 11, dans lequel le dispositif de commande du champ de déflexion est configuré pour appliquer une tension électrique moyenne d'au moins deux filtres l'un par rapport à l'autre.

**13.** Système d'inspection selon l'une des revendications 6 à 12, dans lequel les électrodes du filtre en peigne comportent dans la direction du faisceau une extension, qui correspond à environ 0,5 fois à 1,5 fois la largeur de l'ouverture dans la zone des électrodes.

**14.** Système d'inspection selon l'une des revendications 6 à 13, dans lequel le premier ou/et le deuxième ou/et le troisième filtres sont configurés en outre comme filtre en peigne, dans les électrodes desquels des tensions électriques sélectionnables peuvent être appliquées par le dispositif de commande.

**15.** Système d'inspection selon l'une des revendications 1 à 14, dans lequel le dispositif d'illumination comporte une source de photons (91) pour éclairer le champ, dans lequel les particules chargées sortant des points de la zone représentée (7) comprennent des photoélectrons produits par des photons de la source de photons (91).

**16.** Système d'inspection selon la revendication 15, dans lequel un dispositif de déflexion (95) est prévu avec un miroir mobile, pour déplacer le champ éclairé par déplacement du miroir.

**17.** Système d'inspection selon l'une des revendications 1 à 16, dans lequel le dispositif d'illumination comporte une source d'électrons (31) pour éclairer le champ, et dans lequel les particules chargées sortant des points de la zone représentée (7) comprennent des électrons secondaires et/ou des électrons à rétrodiffusion et/ou des électrons à transmission produits par des électrons de la source d'électrons (31).

**18.** Système d'inspection selon la revendication 17, dans lequel le dispositif d'illumination comporte au moins un diaphragme (35) pour la formation d'un faisceau d'illumination (29) éclairant le champ et/ou pour l'ajustage d'une ouverture numérique de l'illumination.

**19.** Système d'inspection selon les revendications 17 ou 18, dans lequel le dispositif d'illumination (31c) et le premier dispositif à lentille de focalisation (15c') sont agencés sur les côtés opposés du plan de l'objet et le dispositif d'illumination (31 c) comporte un deuxième déflecteur (15c) pouvant être commandé par la commande (25c), afin de dévier le faisceau pour le déplacement du champ.

**20.** Système d'inspection selon les revendications 17 ou 18, dans lequel le dispositif d'illumination (31 ; 31a ; 31b) et le premier dispositif à lentille de focalisation (15 ; 15a; 15b) sont agencés sur le même côté par rapport au plan objet.

**21.** Système d'inspection selon la revendication 20, dans lequel un dispositif de guidage de faisceau est prévu pour guider les électrons émis par la source (31; 31a ; 31b) à travers l'ouverture fixe du faisceau (27 ; 27a ; 27b) dans la direction de l'objet (3), les électrons se dirigeant vers l'objet (3) traversent aussi le premier déflecteur (23, 24) et le premier dispositif à lentille de focalisation (15).

**22.** Système d'inspection selon la revendication 21, dans lequel, en traversant le premier déflecteur (15), les électrons entrants présentent une énergie cinétique plus élevée que les électrons passant de l'objet (3) au détecteur (5) et dans lequel le premier déflecteur (23, 24) est configuré de telle manière que le champ de déflexion produit par celui-ci pour les électrons se dirigeant vers l'objet (3) et les électrons se dirigeant de l'objet (3) au détecteur (5) produit des déviations (M) sensiblement identiques.

**23.** Système d'inspection selon la revendication 22, dans lequel le premier déflecteur comporte au moins une zone (37) avec un champ de déflexion électrique modifiable et un champ de déflexion magnétique (40) modifiable par la commande, dans lequel des directions de champ du champ de déflexion électrique et du champ de déflexion magnétique, ainsi que des directions de mouvement des électrons dans cette zone (37) sont alignés par paire essentiellement de manière orthogonale les unes aux autres.

**24.** Système d'inspection selon la revendication 23, dans lequel la commande (25) commande le premier déflecteur (23, 24) de telle manière que dans au moins l'une des zones (37) l'équation

$$B = k\,E$$

est sensiblement satisfaite, dans laquelle
B est une intensité de champ du champ magnétique dans la zone (37),
E est une intensité de champ du champ électrique dans la zone (37) et
k est une constante.

**25.** Système d'inspection selon l'une des revendications précédentes, dans lequel un filtre d'énergie d'imagerie (67) est prévu pour les particules chargées, dans le trajet du faisceau d'illumination entre l'ouverture fixe du faisceau (27) et le détecteur (5).

26. Système d'inspection selon l'une des revendications précédentes dans lequel le premier déflecteur comprend un dispositif de déflexion (23, 24) pour dévier un premier faisceau traversant le dispositif de déflexion (23, 24) dans une première direction, avec un volume (37) pour la production d'un champ de déflexion pour le premier faisceau, dans lequel le dispositif de déflexion (23, 24) comprend:

un agencement d'enroulement de conducteurs avec une pluralité d'enroulements de conducteurs (47) agencés et répartis dans la périphérie autour d'un axe (z) pour la production d'un champ de déflexion magnétique (40) dans le volume (37) ;

un agencement d'électrodes avec une pluralité d'électrodes (38) agencées et réparties dans la périphérie autour de l'axe (z) pour la production d'un champ de déflexion électrique dans le volume (37) ;

la commande (25) étant configurée pour le réglage des courants à alimenter respectivement par les enroulements de conducteurs (47) et pour le réglage des tensions à alimenter respectivement par les électrodes (38) ;

le dispositif de déflexion (23, 24) étant configuré en plus pour la déflexion d'un deuxième faisceau (9, 10) de particules chargées traversant le dispositif de déflexion dans une deuxième direction opposée à la première direction, et dans lequel la commande règle les courants et les tensions de telle manière que le premier faisceau (29) est dévié autour d'un angle ((β), qui est sensiblement égal et opposé à un angle (-β), autour duquel est dévié le deuxième faisceau (9, 10).

27. Système d'inspection selon la revendication 26, dans lequel la disposition des enroulements de conducteurs comporte une ou plusieurs bagues (43) agencées à une distance axiale les unes des autres, fabriquées dans un matériau à haute perméabilité magnétique et dans lequel les enroulements de conducteurs (47) entourent respectivement au moins une des bagues (43).

28. Système d'inspection selon l'une des revendications 1 à 25, dans lequel le premier déflecteur comprend un dispositif de déflexion (23, 24) pour dévier un premier faisceau traversant le dispositif de déflexion (23, 24) dans une première direction d'un premier faisceau (29) de particules chargées, avec un volume (37) pour mise à disposition d'un champ de déflexion pour le premier faisceau, sachant que le dispositif de déflexion (23, 24) comprend :

un agencement d'enroulements de conducteurs avec une pluralité d'enroulements de conducteur (47) agencés et répartis dans le sens périphérique autour d'un axe (z) pour la production d'un champ de déflexion magnétique (40) dans le volume (37) ;

un agencement d'électrodes avec une pluralité d'électrodes (38) agencées et réparties dans la périphérie autour d'un axe (z) pour la production d'un champ de déflexion électrique dans le volume (37) ;

la commande (25) étant configurée pour le réglage des courants à alimenter respectivement par les enroulements de conducteurs (47) et pour le réglage des tensions à alimenter respectivement par les électrodes (38),

la disposition des enroulements de conducteurs comportant une ou plusieurs bagues (43) agencées à une distance axiale les unes des autres, fabriquées dans un matériau à haute perméabilité magnétique et dans lequel les enroulements de conducteurs (47) entourent respectivement au moins une des bagues (43).

29. Système d'inspection selon les revendications 27 ou 28, dans lequel le dispositif de déflexion comprend en outre un tube à vide, dans lequel les bagues sont agencées radialement à l'extérieur et les électrodes radialement à l'intérieur du tube à vide.

Fig. 1

Fig. 2

Fig. 3

Fig. 4

Fig. 5

Fig. 6a     Fig. 6b     Fig. 6c

## Fig. 7

## Fig. 8

Fig. 9

Fig. 10

Fig. 11

Fig. 12

Fig. 13

Fig. 14

Fig. 15

Fig. 16